(19) Europäisches Patentamt
European Patent Office
Office européen des brevets

(11) **EP 4 741 859 A2**

(12) **EUROPEAN PATENT APPLICATION**

(43) Date of publication:
**13.05.2026 Bulletin 2026/20**

(21) Application number: **25199911.6**

(22) Date of filing: **03.09.2025**

(51) International Patent Classification (IPC):
**G01R 33/00** *(2006.01)*  **G01R 33/038** *(2006.01)*
**G01R 33/07** *(2006.01)*  **G01R 33/09** *(2006.01)*

(52) Cooperative Patent Classification (CPC):
**G01R 33/0052; G01R 33/038; G01R 33/07;**
**G01R 33/09;** G01D 5/147

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.11.2024 US 202418938948**

(71) Applicant: **Allegro MicroSystems, LLC
Manchester, NH 03103 (US)**

(72) Inventor: **LASSALLE-BALIER, Rémy
91440 Bures sur Yvette (FR)**

(74) Representative: **South, Nicholas Geoffrey et al
Venner Shipley LLP
200 Aldersgate
London EC1A 4HD (GB)**

(54) **SYSTEMS, METHODS, AND STRUCTURES FOR IMPROVING MAGNETIC FIELD SENSOR PERFORMANCE**

(57)  Disclosed are example systems, methods, and structures for improving magnetic field sensor performance. In particular, described are example systems, methods, and structures for improving magnetic field sensor performance in applications where magnetic field sensing elements detect a deflection of a magnetic field generated by a magnet. Systems, methods, and structures disclosed herein may provide a sensor device that includes magnetic field sensing elements and a plurality of magnet structures embedded in a semiconductor die. In some embodiments, the plurality of magnet structures may be configured to generate a magnetic field corresponding to a layout of the magnetic field sensing elements in the semiconductor die.

*FIG. 4*

# Description

## BACKGROUND

Sensor devices are often used to monitor parameters of a system. For example, sensor devices may be used to measure speed and/or direction of rotation of a rotation object, such as of a wheel. The speed and/or direction measurements may then be used, such as in the implementation of driver assistance applications.

As another example, sensor devices may be used to measure a position or angle of rotation of a rotation object, such as of a rotor of an electric motor. The measurement information may then be used to control the motor. For example, a controller may continuously receive a measured angle of rotation of the rotor, and may use this information to commutate the motor. That is, the measured angle information may be used by the controller to switch currents in motor windings, producing magnetic fields that cause the rotor to rotate. The controller can then control aspects of the motor, such as speed and torque, based on the measured angle information.

Numerous applications, spanning from industrial automation and robotics, to self-parking and power steering applications in automobiles, may require monitoring of a rotation speed, direction, angle, or position of a rotating object.

## SUMMARY

Disclosed are example systems, methods, and structures for improving magnetic field sensor performance. In particular, described are example systems, methods, and structures for improving magnetic field sensor performance in applications where magnetic field sensing elements detect a deflection of a magnetic field generated by a magnet. Systems, methods, and structures disclosed herein may provide a sensor device that includes magnetic field sensing elements and a plurality of magnet structures embedded in a semiconductor die. In some embodiments, the plurality of magnet structures may be configured to generate a magnetic field corresponding to a layout of the magnetic field sensing elements in the semiconductor die. Using systems, methods, and structures disclosed herein, a sensor device may be provided that is less susceptible to misalignment, that has improved resistance to temperature cycling, that has improved resolution, that has improved noise characteristics, that has better immunity to magnetic stray fields, that has less temperature dependence, that is easier to install in a system, that has reduced magnetic offset, and/or that is more compact.

In accordance with some embodiments, there is provided a sensor device. The sensor device comprises a plurality of magnetic field sensing elements formed into bridge circuits on a first side of a semiconductor die. The sensor device further comprises a plurality of magnet structures embedded in a second side of the semiconductor die.

In some embodiments, the plurality of magnetic field sensing elements comprise one or more giant magnetoresistance (GMR) elements, one or more tunneling magnetoresistance (TMR) elements, or one or more Hall plate elements.

In further embodiments, the plurality of magnet structures generate a magnetic field that biases the plurality of magnetic field sensing elements along a first axis, and the plurality of magnetic field sensing elements are maximally sensitive to the magnetic field along a second axis that is orthogonal to the first axis.

In still further embodiments, a first magnet structure of the plurality of magnet structures has a first volume and a second magnet structure of the plurality of magnet structures has second volume different than the first volume.

In some embodiments, the semiconductor die has a first axis and the plurality of magnet structures are symmetrical about the first axis.

In further embodiments, the semiconductor die has a second axis and the plurality of magnet structures are symmetrical about the second axis.

In still further embodiments, the first axis is orthogonal to the second axis.

In some embodiments, the walls of the semiconductor die surround the plurality of magnet structures.

In further embodiments, at least some of the plurality of magnet structures have dimensions that differ from others of the plurality of magnet structures.

In still further embodiments, the plurality of magnet structures generate a magnetic field, and the plurality of magnetic field sensing elements comprise at least four magnetic field sensing elements configured to sense a deflection of the magnetic field caused by a target that rotates in proximity to the sensor device.

In some embodiments, each of the magnetic field sensing elements comprises a first segment and a second segment, and the magnetic field applies a bias that is the same along a first axis of the first segments of each of the at least four magnetic field sensing elements on average over a period of a rotation of the target.

In further embodiments, the magnetic field applies no bias along a second axis of each of the at least four magnetic field sensing elements on average over a period of a rotation of the target.

In still further embodiments, the magnetic field generated by the plurality of magnet structures applies a constant bias across a region of the first side of the semiconductor die on average over a period of rotation of the target.

In some embodiments, the magnetic field generated by the plurality of magnet structures applies a bias across each of at least four regions of the first side of the semiconductor die, and the bias applied to each of the at least four regions is constant across that region on average over a period of rotation of the target.

In further embodiments, each of the plurality of magnet structures is formed in a respective cavity in the second side of the semiconductor die.

In still further embodiments, at least one of the cavities has a top along the second side of the semiconductor die and a bottom within the semiconductor die, wherein the at least one cavity is formed with an undercut such that the bottom is wider than the top.

Furthermore, in accordance with some embodiments, there is provided a method. The method comprises identifying regions of a first side of a semiconductor die for placement of magnetic field sensing elements, and dimensioning a plurality of magnet structures for a second side of the semiconductor die. The method further comprises generating a mask for etching cavities into the second side of the semiconductor die based at least in part on the dimensioning of the plurality of magnet structures. The method still further comprises causing the cavities to be etched into the second side of the semiconductor die based on the mask.

In some embodiments, the method further comprises causing the magnetic field sensing elements to be formed onto the regions of the first side of the semiconductor die.

In further embodiments, the magnetic field sensing elements comprise at least one of a giant magnetoresistance (GMR) element, a tunneling magnetoresistance (TMR) element, or a Hall plate element.

In still further embodiments, the magnetic field sensing elements are configured to be biased by a magnetic field generated by the plurality of magnet structures along a first axis, and to be maximally sensitive to the magnetic field along a second axis orthogonal to the first axis.

In some embodiments, the method further comprises dimensioning the plurality of magnet structures to generate a magnetic field, wherein the magnetic field sensing elements comprises at least four magnetic field sensing elements configured to sense a deflection of the magnetic field caused by a target that rotates in proximity to the sensor device.

In further embodiments, the method further comprises dimensioning the plurality of magnet structures to generate the magnetic field to apply a bias that is the same along a first axis of each of the regions on average over a period of rotation of the target.

In still further embodiments, the method further comprises dimensioning the plurality of magnet structures to generate the magnetic field such that no bias is applied along a second axis of each of the regions on average over a period of rotation of the target.

In some embodiments, the method further comprises dimensioning the plurality of magnet structures to generate the magnetic field such that the bias applied to each of the regions is constant across that region over a period of rotation of the target.

In further embodiments, the method further comprises causing at least one of the cavities of the semiconductor die to be etched such that the at least one cavity has a top along the second side of the semiconductor die, a bottom within the semiconductor die, and an undercut along at least one side of the cavity, such that the bottom is wider than the top.

In still further embodiments, the method further comprises dimensioning the semiconductor die to form one or more walls between a set of two or more of the magnet structures. The method still further comprises generating the mask for etching the cavities based at least in part on the dimensioning of the one or more walls.

Before explaining example embodiments consistent with the present disclosure in detail, it is to be understood that the disclosure is not limited in its application to the details of constructions and to the arrangements set forth in the following description or illustrated in the drawings. The disclosure is capable of being practiced and carried out in various ways. Also, it is to be understood that the phraseology and terminology employed herein, as well as in the abstract, are for the purpose of description and should not be regarded as limiting.

It is to be understood that both the foregoing general description and the following detailed description are explanatory only and are not restrictive of the claimed subject matter.

## BRIEF DESCRIPTION OF THE DRAWINGS

The accompanying drawings are incorporated in and constitute part of this specification. The drawings, together with the description, illustrate and serve to explain the principles of various example embodiments of the disclosure.

FIG. 1A shows a block diagram of an example system for sensing a magnetic field.

FIG. 1B shows a block diagram of an example sensor device for sensing a magnetic field, with a bridge configuration of magnetic field sensing elements.

FIG. 2A shows a diagram of an example giant magnetoresistance (GMR) element.

FIG. 2B shows a diagram of an example tunneling magnetoresistance (TMR) element.

FIG. 3 shows a block diagram of another example system for sensing a magnetic field.

FIG. 4 shows an example system, including a sensor device, magnet, and rotating target.

FIG. 5 shows a diagram of an example layout of magnetic field sensing elements with respect to a magnet.

FIG. 6 shows a diagram of an example layout of magnetic field sensing elements.

FIG. 6A shows a circuit representation of example left and right bridges formed from the magnetic field sensing elements of FIG. 6.

FIG. 6B shows a circuit representation of example symmetric and three point bridges formed from the magnetic field sensing elements of FIG. 6.

FIG. 7A shows a diagram of an example layout of a substrate and example regions for placing magnetic field sensing elements.

FIG. 7B shows another diagram of an example layout of a substrate and example regions for placing magnetic field sensing elements.

FIG. 8A shows a diagram of an example layout of a substrate for placing magnet structures and example enlarged regions of a substrate for placing magnetic field sensing elements, consistent with embodiments of the present disclosure.

FIG. 8B shows a diagram of an example layout, showing the regions of a substrate for placing magnetic field sensing elements of FIG. 7B and the example locations for placing magnet structures of FIG. 8A, for comparison of the sizes of the regions with those of FIG. 8A.

FIG. 9A is a graph showing plots of magnetic field biases along a first axis generated by the plurality of magnet structures of FIG. 8A at different locations of the semiconductor die.

FIG. 9B is a graph showing additional plots of magnetic field biases along a first axis generated by the plurality of magnet structures of FIG. 8A at different locations of the semiconductor die.

FIG. 9C is a graph showing plots of magnetic field offsets along a second axis generated by the plurality of magnet structures of FIG. 8A at different locations of the semiconductor die.

FIG. 10 shows a diagram of an example cavity in a substrate for embedding a magnet structure, consistent with embodiments of the present disclosure.

FIG. 11 shows a diagram of example locations for embedding magnet structures in a semiconductor die and example dimensions of the magnet structures that may be varied, consistent with embodiments of the present disclosure.

FIG. 12 shows a diagram of example locations for embedding magnet structures in a semiconductor die, example axes of symmetry of the magnet structures, and example groups of the magnet structures, consistent with embodiments of the present disclosure.

FIG. 13 shows a diagram of example locations for embedding magnet structures in a semiconductor die and example columns of the magnet structures, consistent with embodiments of the present disclosure.

FIG. 14 shows a diagram of example locations for embedding magnet structures in a semiconductor die and example rows of the magnet structures, consistent with embodiments of the present disclosure.

FIG. 15A shows a substrate and example locations for placing magnetic field sensing elements.

FIG. 15B shows circuit representations of example bridges formed from the magnetic field sensing elements of FIG. 15A.

FIG. 16 shows an example process for configuring a layout of magnet structures and causing cavities in a semiconductor die to be etched according to the layout, consistent with embodiments of the present disclosure.

FIG. 17 shows an example environment, consistent with embodiments of the present disclosure.

FIG. 18 shows an example computing device, consistent with embodiments of the present disclosure.

The drawings are not necessarily to scale, or inclusive of all elements of a system, emphasis instead generally being placed upon illustrating the concepts, structures, and techniques sought to be protected herein.

## DETAILED DESCRIPTION

Reference will now be made in detail to the embodiments of the disclosure, certain examples of which are illustrated in the accompanying drawings.

In the following description, numerous specific details are set forth regarding the systems, methods, and structures of the disclosed subject matter, and the environment in which such systems, methods, and structures operate, to provide a thorough understanding of the disclosed subject matter. After reading the descriptions provided herein, it will be apparent to one skilled in the art, however, that the disclosed subject matter may be practiced without such specific details. It will also be apparent to one skilled in the art that certain features, which are well known within the art, are not described in detail to avoid unnecessary complication of the description of the systems, methods, and structures described herein. In addition, it will be understood that the embodiments provided below are examples, and that it is contemplated that there are other systems, methods, and structures that are within the scope of the subject matter disclosed herein.

Disclosed are example systems, methods, and structures for improving magnetic field sensor performance. In particular, described are example systems, methods, and structures for improving magnetic field sensor performance in applications where magnetic field sensing elements detect a deflection of a magnetic field generated by a magnet. Systems, methods, and structures disclosed herein may provide a sensor device that includes magnetic field sensing elements and a plurality of magnet structures embedded in a semiconductor die. In some embodiments, the plurality of magnet structures may be configured to generate a magnetic field corresponding to a layout of the magnetic field sensing elements in the semiconductor die. Using systems, methods, and structures disclosed herein, a sensor device may be provided that is less susceptible to misalignment, that has improved resistance to temperature cycling, that has improved resolution, that has improved noise characteristics, that has better immunity to magnetic stray fields, that has less temperature dependence, that is easier to install in a system, that has reduced magnetic offset, and/or that is more compact.

Sensor devices are often used to monitor parameters of a system. For example, sensor devices may be used to measure speed and/or direction of rotation of a rotation object, such as of a wheel. The speed and/or direction measurements may then be used, such as in the implementation of driver assistance applications.

As another example, sensor devices may be used to measure a position or angle of rotation of a rotation object, such as of a rotor of an electric motor. The measurement information may then be used to control the motor. For example, a controller may continuously receive a measured angle of rotation of the rotor, and may use this information to commutate the motor. That is, the measured angle information may be used by the controller to switch currents in motor windings, producing magnetic fields that cause the rotor to rotate. The controller can then control aspects of the motor, such as speed and torque, based on the measured angle information.

Numerous applications, spanning from industrial automation and robotics, to self-parking and power steering applications in automobiles, may require monitoring of a rotation speed, direction, angle, or position of a rotating object.

A magnetic field sensor device may be used to determine a speed, direction, angle, or position of rotation of a rotation object. With a magnetic field sensor device, one or more magnetic field sensing elements of the sensor device that are responsive to a magnetic field may be positioned near a rotation object and may detect a magnetic field associated with the rotation object.

An object (e.g., rotating object) monitored by a sensor device is often referred to as a target. Accordingly, an object whose characteristics are sensed by the sensor device may be referred to as a "target" herein.

In some systems, a target is a magnet that generates a magnetic field. In such systems, the magnet may by the rotating object itself if the object is magnetized, or may otherwise by a magnet that is attached to the rotating object so as to rotate with the rotating object.

In some systems, a target may be made of a ferromagnetic material, such as a ferromagnetic steel (e.g., ferromagnetic carbon steel). In these systems, a magnet may generate a magnetic field, and deflections of the magnetic field may be sensed by the sensor device. For example, a target may be a ferromagnetic gear that may be rotated and that has gear teeth. A biasing magnet may be positioned in proximity to the ferromagnetic target and may generate a magnetic field. As the target rotates, the gear teeth of the target may cause deflections in (or modulate) the magnetic field generated by the biasing magnet. These deflections may be detected by one or more magnetic field sensing elements to determine a rotation speed, direction, position, and/or angle of the target. In some systems, the one or more magnetic field sensing elements of a sensor device may be positioned between a biasing magnet and a ferromagnetic target. Such an arrangement may be referred to herein as a "back-bias" arrangement.

A person of ordinary skill in the art would recognize that a magnet may be a permanent magnet that stays magnetized once magnetized, a temporary magnet that behaves like a magnet only when near a magnetic field, an electromagnet that behaves like a magnet only when electricity is applied, or any other type of magnet. A person of ordinary skill in the art would recognize that a magnet may be made of any type of magnetic material, such as neodymium (e.g., neodymium-iron-boron (NdFeB)), samarium cobalt (e.g., SmCo), alnico (e.g., aluminum, nickel, cobalt), ceramic or ferrite (e.g., strontium carbonate, iron oxide) or any other type of magnetic material. A magnet may be diametrically magnetized and/or axially magnetized. A magnet may have a north pole and a south pole, or several north poles and south poles. A magnet may take a variety of different forms, such as a disc magnet, a bar magnet, a horseshoe magnet, a ring magnet, or a cylinder magnet, as just some examples.

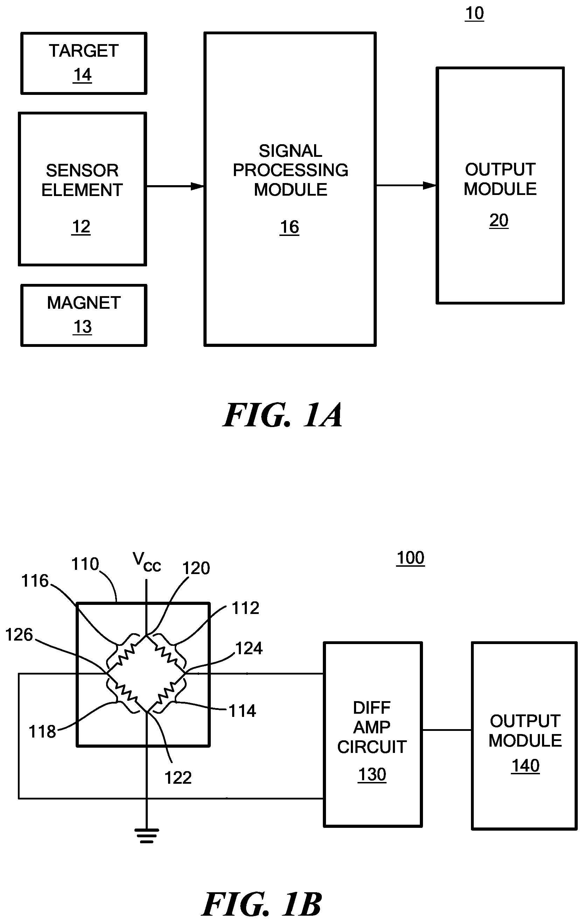

FIG. 1A shows a block diagram of an example system 10 for sensing a magnetic field. System 10 includes one or more magnetic field sensing elements 12. A magnet 13 may be positioned in relation to magnetic field sensing element(s) 12 and may generate a magnetic field. Magnet 13 may be any of the types of magnets previously discussed, or may be composed of a plurality of magnet structures (as will further be discussed herein). A target 14 made of a ferromagnetic material may also be positioned in proximity to magnetic field sensing element(s) 12. As shown in FIG. 1A, magnetic field sensing element(s) 12 may be positioned between magnet 13 and target 14, such that system 10 has a back-bias arrangement.

Magnetic field sensing element(s) 12 may sense changes in the magnetic field generated by magnet 13 as target 14 rotates and features (e.g., gear teeth) of target 14 pass by magnetic field sensing element(s) 12. For example, magnetic field sensing element(s) 12 may sense deflection (or modulation) of the magnetic flux lines of the magnetic field generated by magnet 13 as the features of target 14 pass by.

A magnetic field sensing element may be any type of element sensitive to a magnetic field. A magnetic field sensing element may be a magnetoresistance element, a magnetotransistor element, or a Hall-effect element. For example, a magnetic field sensing element may be a magnetoresistance element, such as a giant magnetoresistance (GMR) element (e.g., a spin valve element), an Indium Antimonide (InSb) element, an anisotropic magnetoresistance (AMR) element, a tunneling magnetoresistance (TMR) element, or a magnetic tunnel junction (MTJ) element. A magnetic field sensing element may instead by a Hall-effect element, such as a planar Hall element, a vertical Hall element, or a circular vertical Hall (CVH) element.

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of maximum sensitivity perpendicular to a substate, while metal-based or metallic magnetoresistance (e.g., GMR, TMR, AMR, spin-valve) and vertical Hall elements tend to have axes of maximum sensitivity parallel to a substrate.

A magnetic field sensing element may be a single element, or alternatively may include two or more magnetic field sensing elements. Magnetic field sensing elements may be arranged in one of various configurations, such as a half bridge or full (Wheatstone) bridge. Depending on the type of sensor device and application requirements, a magnetic field sensing element may be a device made of a type IV semiconductor material, such as Silicon (Si) or Germanium (Ge), or of a type III-V semiconductor material such as Gallium-Arsenide (GaAs) or an Indium compound such as Indium-Antimonide (InSb). In some embodiments, multiple magnetic field sensing elements in a sensor device may be of the same type of magnetic field sensing element. In some embodiments, there may be different types of magnetic field sensing elements that work together in a sensor device.

In some embodiments, a sensor device may comprise a magnetic field sensing element that comprises two magnetic field sensing elements that are differentially paired. For example, magnetic field sensing elements may be grouped in pairs, such that a difference between outputs of each of the pairs may be determined and output as a differential signal corresponding to the respective pair. Use of differentially-coupled magnetic field sensing elements in a sensor device may allow the sensor device to be immune to stray magnetic fields. For example, any magnetic field strength attributable to the environment, and not to a biasing magnet or to a target, may be sensed by each of the two magnetic field sensing elements in a differentially coupled pair. Because a magnetic field attributable to the environment will be approximately equally sensed at the two differentially paired magnetic field sensing elements (if they are in close proximity), any magnetic field strength measured by magnetic field sensing elements that is attributable to the environment will largely cancel out when a difference is taken between the measurements of the two differentially paired magnetic field sensing elements. That is, common-mode magnetic fields (i.e., common magnetic field strengths sensed by both magnetic field sensing elements in a differential pair) may be canceled out through use of differentially paired magnetic field sensing elements.

A signal processing module 16 may be coupled to magnetic field sensing element(s) 12 and may process signals received from the magnetic field sensing element(s) 12. For example, the signals produced by magnetic field sensing element(s) 12 in response to a sensed magnetic field may be relatively small. Accordingly, a signal processing module 16 may include amplifiers, filters, and/or other circuit components or other known techniques to amplify and/or shape the signals. In some embodiments, the signals may be processed and/or conditioned along channels, or signal paths, within signal processing module 16. Signal processing module 16 may include, for example, one or more amplifiers, analog-to-digital converters (ADCs), resistors, diodes, transistors, capacitors, inductors, memories, processors, and/or any other type of circuit component.

An output module 20 may be coupled to signal processing module 16 and may provide an output signal to another system, such as an electronic control unit (ECU) of an automobile. Output module 20 may include any suitable type of interface for outputting one or more signals. Output module 20 may include one or more of a wired or wireless interface. By way of example, output module 20 may include a current modulator for sending information along a conductor via current pulses, a voltage modulator for sending information along a conductor via voltage pulses, an Inter-Integrated Circuit (I2C) interface, a Controller Area Network (CAN) bus interface, a WiFi interface, an Ethernet interface, a Universal Serial Bus (USB) interface, a local area network (LAN) interface, a cellular (e.g., 5G) interface, and/or any other suitable type of interface.

FIG. 1B shows a block diagram of an example sensor device 100 for sensing a magnetic field. Sensor device 100 may include one or more magnetic field sensing elements. For example, FIG. 1B illustrates sensor device 100 as having four magnetoresistance (MR) (e.g., GMR, TMR) sensing elements, magnetic field sensing element 112, magnetic field sensing element 114, magnetic field sensing element 116, and magnetic field sensing element 118. In some embodiments, the magnetic field sensing elements may be the same as magnetic field sensing element(s) 12, with additional details shown in FIG. 1B. The magnetic field sensing elements may be arranged in the form of a bridge circuit 110, such as a half bridge or full (Wheatstone) bridge. As shown in FIG. 1B, bridge circuit 110 may include magnetic field sensing elements disposed on respective branches of the bridge. As will be further described herein, each of the magnetic field sensing elements may be further divided into two or more segments to provide misalignment compensation for the sensor device.

In the example shown in FIG. 1B, one end of magnetic field sensing element 112 and one end of magnetic field sensing element 116 may be connected in common to a power supply terminal (labeled as $V_{CC}$ in FIG. 1B) via a node 120. One end of magnetic field sensing element 114 and one end of magnetic field sensing element 118 may be connected in common to a ground terminal via a node 122. Other ends of magnetic field sensing element 112 and magnetic field sensing element 114 may be connected to a node 124, and other ends of magnetic field sensing element 116 and magnetic field sensing element 118 may be connected to a node 126.

In the example shown in FIG. 1B, nodes 124 and 126 are connected to a differential amplifier circuit 130. In some embodiments, differential amplifier circuit 130 may be a part of a signal processing module 16, though the disclosure is not so limited. A first output of differential amplifier circuit 130 may be connected to output module 140. In some embodiments, output module 140 may be the same as output module 20, though the disclosure is not so limited.

Magnetic field sensing planes of magnetic field sensing elements 112, 114, 116, 118 may react to a magnetic field with corresponding changes in resistance. In some embodiments, some of the magnetic field sensing elements may experience maximum and minimum resistances at different times than certain other magnetic field sensing elements. This may be due, for example, to the differing locations and/or orientations of the magnetic field sensing elements. For example, in FIG. 1B, magnetic field sensing elements 112 and 118 are oriented differently than magnetic field sensing elements 114 and 116, such that the maximum and minimum resistances of magnetic field sensing elements 112 and 118 may not occur at the same time as the maximum and minimum resistances of magnetic field sensing elements 114 and 116 when a magnetic field is generated by a magnet (e.g., magnet 13) and a target (e.g., target 14) rotates. Current may flow from the power supply terminal to ground, and voltages at nodes 124, 126 (mid-point voltages) may be output to differential amplifier circuit 130. The voltages at nodes 124, 126 may be proportional to the resistances of the magnetic field sensing elements, and therefore may also be proportional to the strength of the magnetic field sensed by the magnetic field sensing elements.

The voltage signals output at nodes 124, 126 may be sinusoidal over time as the target (e.g., target 14) rotates. The voltage signals may be phase-shifted with respect to each other due to different locations and/or orientations of the magnetic field sensing elements, as discussed above. A rotation of the target that results in a period (or cycle) of a sinusoidal signal in the sensor device may be referred to as a "period of rotation of the target" herein. In the case of a ferromagnetic target with gear teeth, such a period of rotation of the target may correspond to a rotation of the target that results in one gear tooth passing the sensor device. By contrast a full 360 degree rotation of the target may be referred to as a "full rotation of the target" herein.

The term "magnetoresistance" refers to the dependence of the electrical resistance of a structure (e.g., magnetic field sensing element) on the strength of an external magnetic field. Magnetoresistance may be characterized as:

$$\text{Equation 1: } \delta_H = \frac{R(0) - R(H)}{R(0)}$$

where $\delta_H$ is a value of magnetoresistance, $R(H)$ is the resistance of the structure in a magnetic field $H$, and $R(0)$ corresponds to resistance of the structure when $H=0$.

The term "giant magnetoresistance" indicates that the value of $\delta_H$ for multilayer structures may significantly exceed anisotropic magnetoresistance. Giant magnetoresistance (GMR) is a quantum mechanical magnetoresistance effect observed in thin-film structures composed of alternating ferromagnetic and non-magnetic conductive layers. The effect is observed as a significant change in the electrical resistance of the structure depending on whether the magnetization of adjacent ferromagnetic layers are in a parallel or in an antiparallel alignment. The overall resistance may be relatively low for a parallel alignment and relatively high for an antiparallel alignment. A magnetization direction may be controlled, for example, by applying an external magnetic field. The effect of the changing resistance of the structure is due to the dependence of electron scattering on spin orientation. A bridge of four identical GMR magnetic field sensing elements may be insensitive to a uniform magnetic field, and may be reactive when directions of the magnetic field are antiparallel in neighboring arms of the bridge.

The term "tunneling magnetoresistance" (TMR) refers to a quantum mechanical magnetoresistive effect observed in thin-film structures composed of ferromagnetic layers separated by a thin insulating layer. With the insulating layer being thin, electrons may tunnel from one of the ferromagnetic layers to another ferromagnetic layer. The effect is observed as a change in the electrical resistance of a structure depending on whether the magnetization of the ferromagnetic layers are in a parallel or in an antiparallel arrangement. A magnetization direction may be controlled, for example, by applying an external magnetic field.

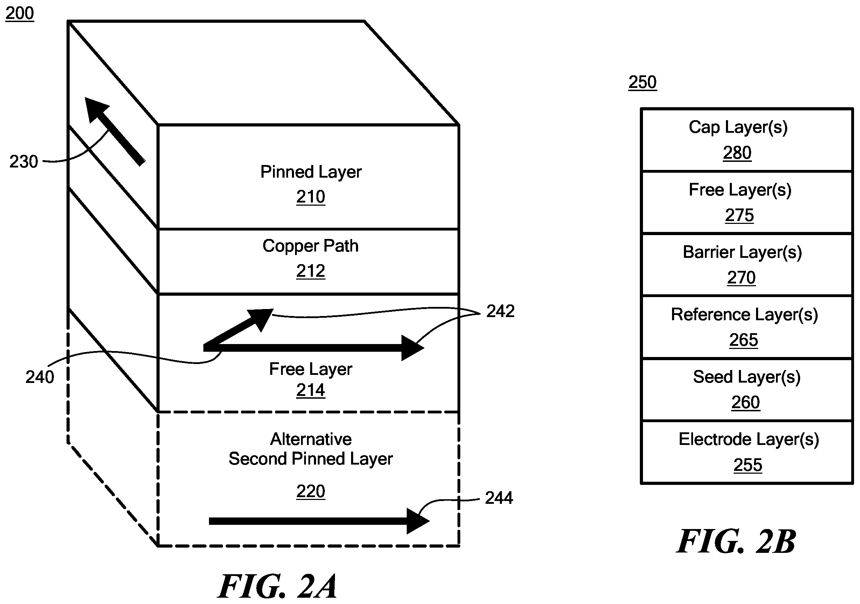

FIG. 2A shows a diagram of an example giant magnetoresistance (GMR) element 200 that may be used as a magnetic field sensing element. GMR element 200 may include a pinned layer 210, a metal (e.g., Copper) path 212, and a free layer 214. The magnetic orientation of pinned layer 210 may be fixed (e.g., in a direction 230). The magnetic orientation of free layer 214 may be maintained in a selected alignment through anisotropy or with an alternative second pinned layer 220, each of which may provide a pinning field $H_{an}$ 242 (see FIG. 2A). Alternative second pinned layer 220 (if used) may have a magnetic orientation that is fixed (e.g., in a direction 244). The magnetic orientation of free layer 214 may rotate pinning field 242 based on an applied magnetic field.

A GMR element 200 may be driven by a voltage, such that a current flows in a direction sideways through the GMR element, parallel to a film surface in the stack of GMR layers.

FIG. 2B shows a diagram of an example tunneling magnetoresistance (TMR) element 250 that may be used as a magnetic field sensing element. TMR element 250 may include a stack of layers 255-280. For example, electrode layer(s) 255 may comprise one or more conductive material layers, such as one or more metal layers. Seed layer(s) 260 may be positioned on top of electrode layer(s) 255 and may comprise one or more Copper Nickel (CuN) layers, for example. Reference layer(s) 265 may be positioned on top of seed layer(s) 260 and may comprise, for example, one or more Platinum Manganese (PtMn) layers, Iridium Manganese (IrMn) layers, Cobalt Iron (CoFe) layers, and/or Cobalt Iron Boron (CoFeB) layers. For example, in some embodiments, reference layer(s) 265 may include a first layer of PtMn or IrMn on top of seed layer(s) 260, a second layer of CoFe on top of the first layer, a third layer of Ruthenium (Ru) on top of the second layer, and a fourth layer of CoFeB on top of the third layer. Barrier layer(s) 270 may be positioned on top of reference layer(s) 265 and may include one or more layers of Magnesium Oxide (MgO), for example. Free layer(s) 275 may be positioned on top of barrier layer(s) 270 and may include one or more layers of CoFeB, for example. Cap layer(s) 280 may be positioned on top of free layer(s) 275 and may include one or more layers of Tantalum (Ta), for example.

In some embodiments, one or more layers of reference layer(s) 265 may be a pinned layer that is magnetically coupled to one or more other layers of reference layer(s) 265. For example, a layer of CoFe may be positioned on top of a layer of PtMn in reference layer(s) 265, and the layer of CoFe may be a pinned layer that is magnetically coupled to a layer of PtMn. The physical mechanism coupling the layer of CoFe and the layer of PtMn together is sometimes referred to as an exchange bias. Free layer(s) 275 may include a layer of CoFeB. In some embodiments, free layer(s) 275 may include an additional layer of Nickel Iron (NiFe) and a thin layer of Tantalum (Ta) between the CoFeB layer and the NiFe layer.

A TMR element 250 may be driven by a voltage, such that a current flows in a direction through the TMR pillar up or down through the layers of the stack, flowing between cap layer(s) 280 and electrode layer(s) 255 and perpendicular to a surface of electrode layer(s) 255.

That is, current in a TMR element 250 may flow perpendicular to the surface on which the element is mounted, while current in a GMR element 200 may flow parallel to a surface on which the element is mounted.

A GMR element 200 or TMR element 250 may be connected to other components of an electronic circuit or structure. In some embodiments, multiple GMR elements 200 or TMR elements 250 may be coupled together in any of a variety of different configurations to achieve a desired resistance response to an applied magnetic field. The number of GMR and/or TMR elements used and the way in which they are coupled may depend on a desired application for a sensor device.

A person of ordinary skill in the art would understand that FIGs. 2A and 2B and the above description provides just some examples of GMR and TMR elements for context. A person of ordinary skill in the art would recognize that there are many ways to construct GMR and TMR elements. The disclosure herein should not be limited to the examples shown and described with respect to FIGs. 2A and 2B, and should be considered to encompass other known ways of constructing GMR and TMR elements.

The term "layer" as used herein, may refer to one or more materials in a structure. The term "layer" may refer to one or more materials stacked on top, beneath, or to the side of one or more other materials, and should not be interpreted as limiting the orientation or positioning of the one or more materials to any other materials in a structure.

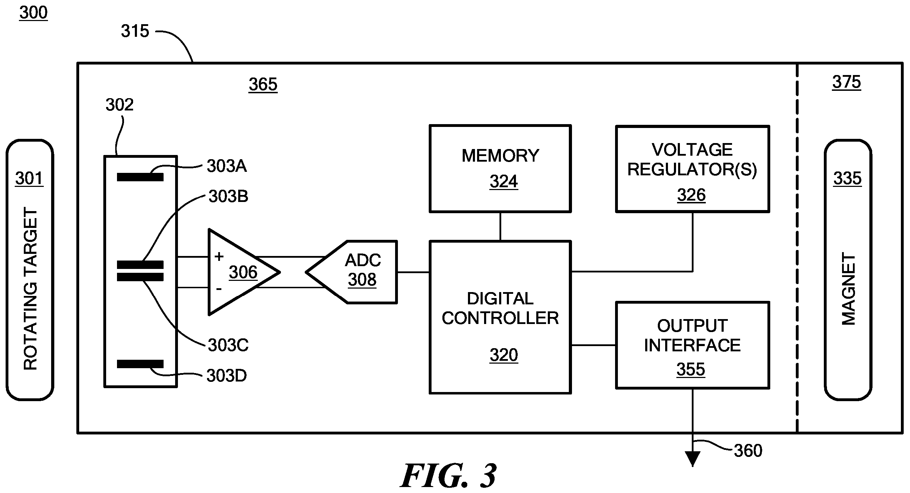

FIG. 3 shows a block diagram of another example system 300 for sensing a magnetic field, consistent with embodiments of the present disclosure. System 300 may include a target 301 that rotates, magnetic field sensing elements 302, other circuitry (e.g., amplifier 306, ADC 308, controller 320, memory 324, voltage regulator 326, output interface 355), and a magnet 335 (e.g., a back-biasing magnet). Rotating target 301 may be a target as discussed above with reference to FIG. 1A (e.g., target 14) and FIG. 1B. For example, target 301 may be a ferromagnetic target with some variation (e.g., gear teeth) on a surface. Magnet 335 may be a magnet as discussed above with reference to FIG. 1A (e.g., magnet 13), and may be a back-biasing magnet for generating a magnetic field.

Magnetic field sensing elements 302 may comprise one or more magnetic field sensing elements. The magnetic field sensing elements may be any one or more of the types of magnetic field sensing elements previously discussed, such as with respect to FIGs. 1A, 1B, 2A, or 2B. FIG. 3 illustrates four magnetic field sensing elements, magnetic field sensing element 303A, magnetic field sensing element 303B, magnetic field sensing element 303C, and magnetic field sensing element 303D. In some embodiments, the magnetic field sensing elements may be GMR elements (see, e.g., FIG. 2A) or TMR elements (see, e.g., FIG. 2B). In some embodiments, pairs of magnetic field sensing elements may be differentially coupled, so as to provide immunity to magnetic stray fields. In some embodiments, the magnetic field sensing elements may be arranged into one or more bridge configurations (see, e.g., FIG. 1B and related discussion above).

The magnetic field sensing elements may be configured to sense a deflection of (or modulation of) the magnetic field generated by magnet 335 as target 301 rotates (e.g., as gear teeth pass the elements and deflect the magnetic field generated by magnet 335). The magnetic field sensing elements may output signals (e.g., voltage signals) (see, e.g., FIG. 1B) that are proportional to a sensed amplitude of the modulated magnetic field, and that may be sinusoidal as target 301 rotates.

In some embodiments, the signals output by the magnetic field sensing elements may be relatively small in amplitude, and may be output to one or more amplifiers 306, which may amplify the signals. The amplified signals may then be output to one or more analog-to-digital converters (ADC) 308. ADC(s) 308 may output one or more signals that are a digital version of the analog signals received by ADC(s) 308.

In some embodiments, the circuitry may include one or more controllers (e.g., digital controller 320). The one or more controllers may receive the digital signal(s) output from ADC(s) 308. A controller may include any suitable type of processing circuitry, such as a digital application-specific integrated circuit (IC) (ASIC), a field programmable gate array (FPGA), a coordinate rotation digital computer (CORDIC) processor, a special-purpose processor, synchronous digital logic, asynchronous digital logic, a general-purpose processor (e.g., microprocessor without interlocked pipelined stages (MIPS) processor, x86 processor), etc. The one or more controllers may also include a clock. The clock may timestamp when signals received from magnetic field sensing elements or other components in the sensor device are recorded (e.g., timestamp with an elapsed amount of time measured by the clock), such that, for example, determined signal values and the times at which the signal values were received may be stored in memory (e.g., memory 324). One of skill in the art would recognize that the clock need not be internal to the one or more controllers, and may instead be an external component connected to the one or more controllers.

The circuitry may also include one or more memories 324. A memory 324 may include any suitable type of volatile and/or non-volatile memory. In some embodiments, a memory may be a non-transitory computer readable medium. By way of example, a memory 324 may include a random-access memory (RAM), a dynamic random-access memory (DRAM), an electrically-erasable programmable read-only memory (EEPROM), and/or any other suitable type of memory. The memory may store instructions that, when executed by controller(s) 320, cause controller(s) 320 to carry out certain determinations, steps, processes, and/or calculations. For example, a memory may store instructions that, when executed by the controller, cause the controller to (1) determine a speed of rotation of the rotation object, (2) determine a direction of rotation of the rotation object, (3) determine a rotation angle or position of the rotation object, and/or (4) cause the controller to output information (e.g., speed, direction, position, angle) to be used by another external system (e.g., an ECU of an automobile).

The circuitry may also include one or more voltage regulators 326. Voltage regulator(s) 326 may, for example, convert or regulate voltage to provide a stable power supply to the circuitry and/or magnetic field sensing elements.

The circuitry may also include one or more output interfaces 355. An output interface 355 may include any suitable type of interface for outputting one or more signals (e.g., output signal(s) 360). Output interface(s) 355 may include one or more of a wired or wireless interface. By way of example, output interface(s) 355 may include a current modulator for sending information along a conductor via current pulses, a voltage modulator for sending information along a conductor via voltage pulses, an Inter-Integrated Circuit (I$^2$C) interface, a Controller Area Network (CAN) bus interface, a WiFi interface, an Ethernet interface, a Universal Serial Bus (USB) interface, a local area network (LAN) interface, a cellular (e.g., 5G) interface, and/or any other suitable type of interface.

In some embodiments, amplifier(s) 306, ADC(s) 308, one or more memories 324, controller(s) 320, and/or voltage regulator(s) 326 may be part of signal processing module 16, though the disclosure is not so limited. In some embodiments, output interface(s) 355 may be part of output module 20, though the disclosure is not so limited.

In some embodiments, magnetic field sensing elements 302, amplifier(s) 306, ADC(s) 308, one or more memories 324, controller(s) 320, voltage regulator(s) 326, and/or output interface(s) 355 may be formed in an integrated circuit (IC) or otherwise packaged together, and may together be referred to as a "sensor device" herein, with a biasing magnet 335 and target 301 being external to the sensor device. In some embodiments, magnetic field sensing elements 302, amplifier(s) 306, ADC(s) 308, one or more memories 324, controller(s) 320, voltage regulator(s) 326, and/or output interface(s) 355 may be packaged together with a biasing magnet 335, such that these components and biasing magnet 335 may together be referred to as a "sensor device" herein. As will be further discussed herein, in some embodiments, magnetic field sensing elements 302, amplifier(s) 306, ADC(s) 308, one or more memories 324, controller(s) 320, voltage regulator(s) 326, and/or output interface(s) 355, and biasing magnet 335, may be formed on the same substrate 315 (e.g., semiconductor die) and may be referred to together as a "sensor device" herein. For example, as will be further discussed herein, magnetic field sensing elements 302, amplifier(s) 306, ADC(s) 308, one or more memories 324, controller(s) 320, voltage regulator(s) 326, output interface(s) 355, and/or any other circuitry or circuit components may be formed on a first side 365 of a substrate 315 (e.g., semiconductor die), and a plurality of magnet structures may be embedded in a second 375 (e.g., opposite) side of the substrate.

In some embodiments, a speed of rotation of a target (e.g., target 301) may be detected, for example, by determining how often a signal output (e.g., voltage signal) from magnetic field sensing elements 302 crosses a particular preset threshold value. For example, a particular a voltage value may be preset in controller 320 or other circuitry of the sensor device, and a controller (e.g., controller 320) may record the number of times a voltage of the signal from magnetic field sensing elements 302 crosses the preset voltage value in a certain amount of time. Speed of rotation of the target may then be calculated, such as by controller 320. Alternatively, a signal pulse 360 may be output by output interface 355 (such as in accordance with an AK protocol) each time the voltage of the signal from the magnetic field sensing elements 302 crosses the preset voltage value, and an external system (e.g., ECU of an automobile) may determine the time between signal pulses to calculate a speed of rotation of the target.

In some embodiments, magnetic field sensing elements 302 may provide two signals representative of the magnetic field that are phase-shifted with respect to one another. A controller (e.g., controller 320) or external system (e.g., ECU) may then determine which of the two signals leads or lags the other (e.g., by looking at relative phase or time difference) to determine a direction of rotation of target 301.

In some embodiments, magnetic field sensing elements 302 may provide two signals representative of the magnetic field that are phase-shifted by 90 degrees from each other (i.e., are orthogonal to each other). The signals may then be used by a controller (e.g., controller 320) or an external system (e.g., ECU) to determine a position or angle of rotation of the target at a given time. For example, the two-argument arctangent function atan2, commonly used in computing and mathematics, may be used to calculate a rotation angle of the target based on the two orthogonal output signals from the magnetic field sensing elements at a given time. Various other techniques may be used to determine a measured rotation angle of the target instead of using an inverse tangent function, such as by using a lookup table, a polynomial fit, or a CORDIC calculation.

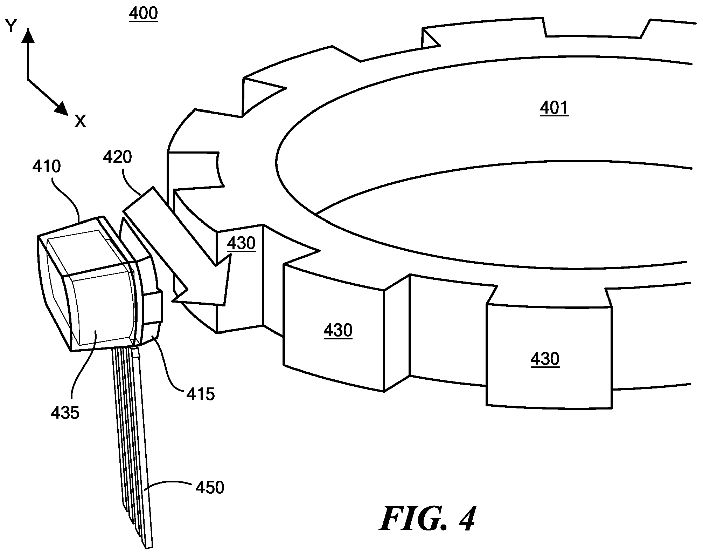

FIG. 4 shows an example system 400 for sensing a magnetic field, including a sensor device 415, magnet 435, and rotating target 401. Sensor device 415 may comprise sensor element 12, signal processing module 16, and output module 20 of FIG. 1A, may be the same as sensor device 100, or may include the magnetic field sensing elements 302, amplifier(s) 306, ADC(s) 308, one or more memories 324, controller(s) 320, voltage regulator(s) 326, and/or output interface(s) 355 of FIG. 3, though the disclosure is not so limited. Target 401 may be any of the targets previously discussed, such as target 14 or target 301, though the disclosure is not so limited. Magnet 435 may be any of the magnets previously discussed, such as magnet 13 of FIG. 1A, or magnet 335 of FIG. 3, though the disclosure is not so limited. In the example of FIG. 4, magnet 435 is a bulk magnet used in a back-bias arrangement. Magnet 435 may be mounted to sensor device 415 (such as with an adhesive) or otherwise packaged with sensor device 415, so as to align magnet 435 with the magnetic field sensing elements of the sensor device.

In some embodiments, target 401 may be a ferromagnetic target with gear teeth 430. In the example of FIG. 4, target 401 is rotating along an axis (e.g., along a Y-axis) past the sensor device in a direction 420 (e.g., an X-axis direction). As previously discussed, magnet 435 may generate a magnetic field, and magnetic field sensing elements in sensor device 415 may sense deflection of (or modulation of) the magnetic field as gear teeth 430 of target 401 rotate past the sensor device. The magnetic field sensing elements may be oriented so as to be sensitive to the magnetic field along the X-axis (or 420) direction, though the disclosure is not so limited.

Leads 450 may provide a power supply (e.g., $V_{CC}$, ground) to the sensor device and a mechanism for providing input (e.g., programming input) and/or output (e.g., output signal 360) signals to the sensor device.

As previously discussed, a back-biasing magnet (e.g., magnet 435) may be packaged with the circuitry of a sensor device (e.g., sensor device 415), such as in a package 410, such that the magnet and sensor device may be referred to herein collectively as a sensor device. As shown in FIG. 4, a bulk back-biasing magnet, such as magnet 435, may by the largest component in a sensor device.

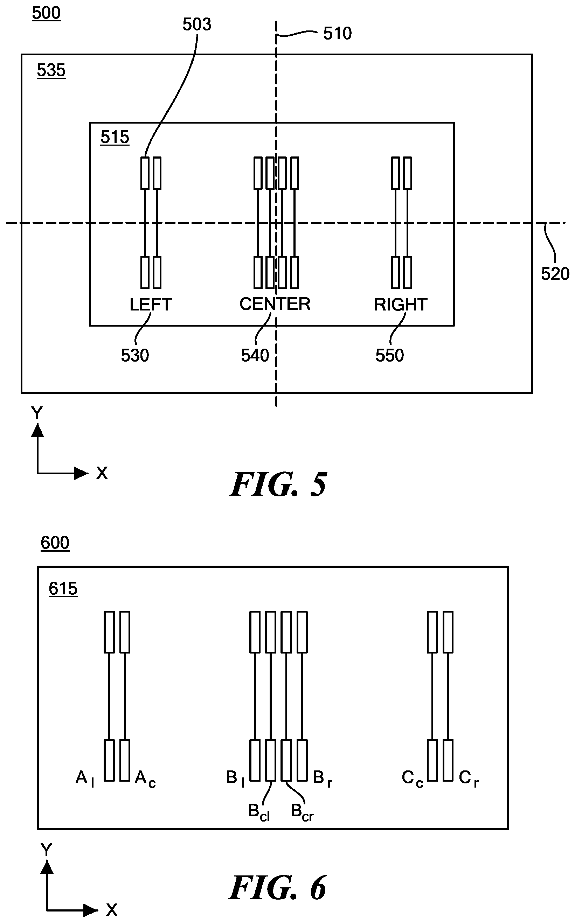

FIG. 5 shows a diagram 500 of an example layout of magnetic field sensing elements 503 on a substrate 515 (e.g., semiconductor die) with respect to a magnet 535 (e.g., a biasing magnet 13, 335, 435). Sensor device 500 may be used, for example, for determining a speed and/or direction of rotation of a target (e.g., target 14, 301, 401). Layout 500 may include first and second bridges formed from three groups of MR (e.g., GMR or TMR) elements (left, center, right), with the MR elements placed in relation to magnet 535 for removing sensitivity to a common mode magnetic field. As shown in the example of FIG. 5, each of the magnetic field sensing elements may comprise two segments coupled in series with each other, with one of the two segments positioned on one side of an axis 520 and another of the two segments positioned on the other side of axis 520. Positioning segments of a magnetic field sensing element in this fashion may compensate for misalignment of magnetic field sensing elements 503 with respect to magnet 535.

For example, magnet 535 may be symmetric about an axis 520 and an axis 510 orthogonal to axis 520. An intersection of axis 520 and axis 510 may be considered to correspond to a center of the front surface magnet 535 and may be considered to correspond to a value of 0 in each of an X coordinate and a Y coordinate along X and Y axes. A magnetic field sensing element 503 may be ideally positioned such that a first segment of magnetic field sensing element 503 is positioned at a coordinate "x1, y1" and a second segment of magnetic field sensing element is positioned at a coordinate "x1, -y1." A second magnetic field sensing element 503 may be ideally positioned such that a first segment of second magnetic field sensing element 503 is positioned at a coordinate "-x1, y1" and a second segment of second magnetic field sensing element 503 is positioned at a coordinate "-x1, -y1." In case of misalignment, the magnetic field sensing elements may move in the positive Y or negative Y direction relative to magnet 535, such that both segments of the magnetic field sensing element may move up or down relative to magnet 535. In such a case, one of the segments of the magnetic field sensing element may increase its bias in the Y axis direction, while the other segment of the magnetic field sensing element may reduce its bias in the Y axis direction, such that the overall bias on the magnetic field sensing element remains substantially the same as when it is ideally positioned. That is, the two opposing sensitivities tend to compensate for each other so as to minimize any effect of Y axis misalignment of a magnetic field sensing element with respect to magnet 535.

First and second bridges may be formed from magnetic field sensing elements 503 located at different X axis positions, as shown in FIG. 5. As shown in FIG. 5, the layout of the magnetic field sensing elements may be such that the elements are symmetric about axis 510 and axis 520. Due to the symmetry of magnetic field sensing elements 503 in semiconductor die 515, when magnetic field sensing elements 503 and magnet 535 are perfectly aligned, the first and second bridges may be symmetric such that magnetic field sensing elements 503 are subject to the same bias and such that magnetic field sensing elements 503 may be immune to stray field when magnetic field sensing elements 503 and magnet 535 are perfectly aligned. A sensor device with magnetic field sensing elements 503 laid out as shown in layout 500 may provide speed and/or direction information regarding a rotating target (e.g., target 14, 301, 401).

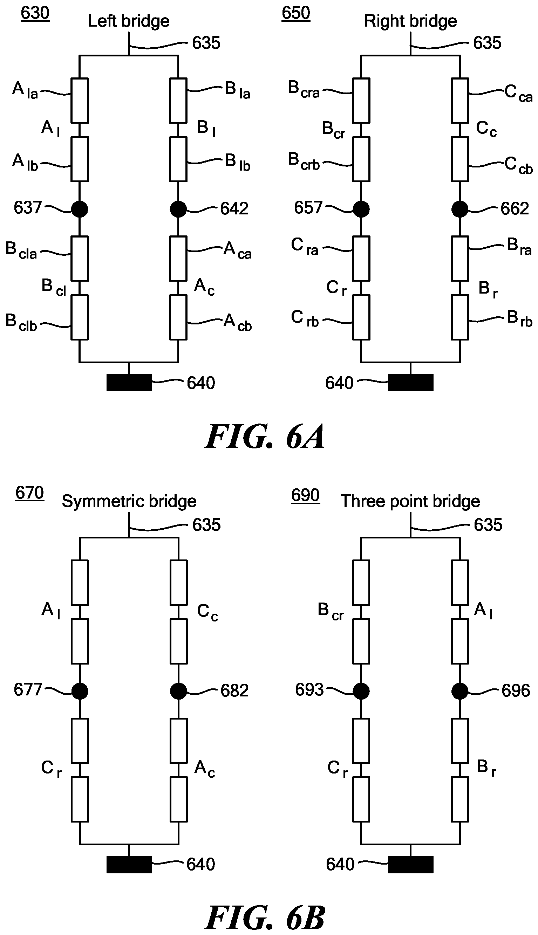

FIG. 6 shows a diagram 600 of an example layout of magnetic field sensing elements (e.g., magnetic field sensing elements $A_l$, $A_c$, $B_l$, $B_{cl}$, $B_{cr}$, $B_r$, $C_c$, $C_r$) in a semiconductor die 615. In FIG. 6, the magnetic field sensing elements are organized into first and second MR (e.g., GMR, TMR) bridges, each bridge having four magnetic field sensing elements, where each magnetic field sensing element comprises first and second segments. FIGs. 6A and 6B show alternative example bridge constructions in which the MR elements of FIG. 6 are subject to opposite bias. For example, FIG. 6A shows a circuit representation of an example bridge construction with left 630 and right 650 bridges formed from the magnetic field sensing elements of FIG. 6. Output signals from the left and right bridges may be used by other circuitry in a sensor device to determine speed and/or direction information associated with a rotating target. For example, subtraction and/or summing of signals output at nodes 637, 642, 657, 662 from the left and right bridges may be used to determine speed and/or direction information associated with a rotating target.

The MR elements are labeled in FIGs. 6, 6A, and 6B such that a subscript "l" refers to a left location, a subscript "r" refers to a right location, a subscript "c" refers to a center location, a subscript "a" refers to a top segment of an MR element, and a subscript "b" refers to a bottom segment of an MR element. Looking at FIG. 6, magnetic field sensing elements $A_x$ and $C_x$ may be referred to as outer magnetic field sensing elements, and magnetic field sensing elements $B_x$ may be referred to as inner magnetic field sensing elements, where "x" is a placeholder for a subscript in FIG. 6. From left to right in FIG. 6, the MR elements are listed as $A_l$, $A_c$, $B_l$, $B_{cl}$, $B_{cr}$, $B_r$, $C_c$, and $C_l$.

As shown in FIG. 6A, in the left bridge 630, MR element $A_l$ may comprise first segment $A_{la}$ and second segment $A_{lb}$, MR element $B_l$ may comprise first segment $B_{la}$ and second segment $B_{lb}$, MR element $B_{cl}$ may comprise first segment $B_{cla}$ and second segment $B_{clb}$, and MR element $A_c$ may comprise first segment $A_{ca}$ and second segment $A_{cb}$. A voltage source 635 (e.g., $V_{CC}$) may be applied at a top of the left bridge, and current may flow through the MR elements to ground 640.

As also shown in FIG. 6A, in the right bridge 650, MR element $B_{cr}$ may comprise first segment $B_{cra}$ and second segment $B_{crb}$, MR element $C_r$ may comprise first segment $C_{ra}$ and second segment $C_{rb}$, MR element $C_C$ may comprise first segment $C_{ca}$ and second segment $C_{cb}$, and MR element $B_r$ may comprise first segment $B_{ra}$ and second segment $B_{rb}$. A voltage source 635 (e.g., $V_{CC}$) may be applied at a top of the left bridge, and current may flow through the MR elements to ground 640.

In the arrangement shown in FIG. 6A, segments of the MR elements may not experience the exact same bias conditions. For example, the bias field, which may be generated by a magnet (e.g., magnet 13, 335, 435, 535) along a Y axis may vary slightly between inner and outer MR elements. This may produce a difference in sensitivity of the MR elements, which may result in an overall sensitivity to a common mode field. However, as will be further discussed herein, a biasing magnet may be constructed by embedding a plurality of semiconductor structures on an opposing side of a substrate from a side where the MR elements are placed. In doing so, the dimensions and placement of the magnet structures may be selected so as to apply a bias field that is more constant across MR elements.

FIG. 6B shows a circuit representation of symmetric 670 and three point 690 bridges formed from the magnetic field sensing elements of FIG. 6. In some embodiments, signals output at nodes 677 and 682 of symmetric bridge 670 may be used to determine a direction of rotation of a target. In some embodiments, signals output at nodes 693 and 696 of three point bridge 690 may be used to determine a speed of rotation of a target. MR elements $A_x$ and $C_x$ may be referred to as outer MR elements, and MR elements $B_x$ may be referred to as central or inner MR elements. As with the bridges in FIG. 6A, each of the MR elements of the bridges in FIG. 6B may comprise two segments, with the two segments positioned in a symmetric manner such that one segment is positioned on one side of an axis (e.g., axis 520) through the center of the biasing magnet, and such that the other segment is positioned on the other side of the axis. A voltage source 635 (e.g., $V_{CC}$) may be applied at a top of the symmetric bridge, and current may flow through the MR elements to ground 640. A voltage source 635 (e.g., $V_{CC}$) may be applied at a top of the three point bridge, and current may flow through the MR elements to ground 640.

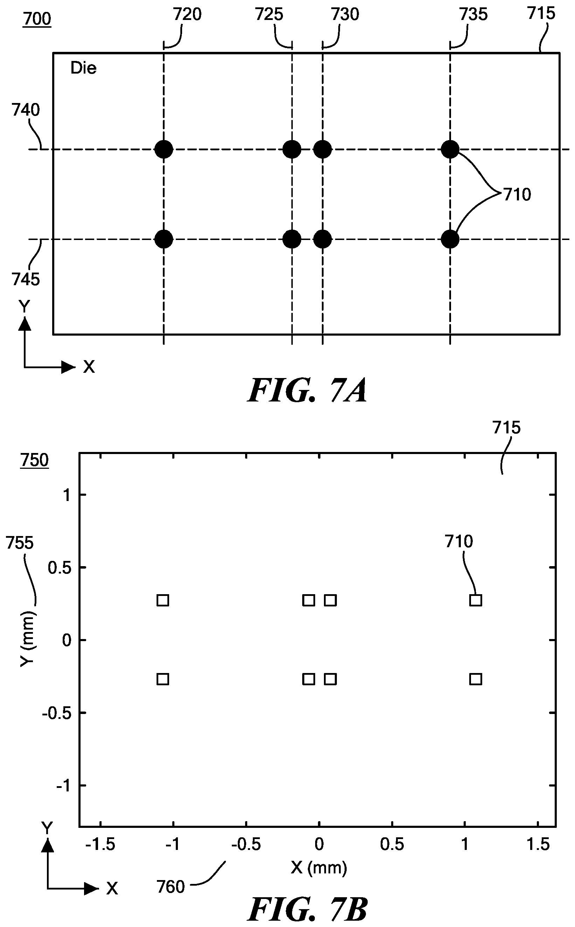

FIG. 7A shows a diagram 700 of an example layout of a substrate 715 (e.g., semiconductor die) and example regions 710 on substrate 715 for placing magnetic field sensing elements, such as MR (e.g., GMR, TMR) elements. In the example of FIG. 7A, eight different regions 710 are shown, though the disclosure is not so limited. Regions 710 may correspond to locations on substrate 715 at which it may be desired to place segments of MR elements, as shown above in FIGs. 5 and 6. For example, in some embodiments, the top segments of MR elements $A_l$ and $A_c$ may be placed in the region where lines 720 and 740 intersect, and the bottom segments of MR elements $A_l$ and $A_c$ may be placed in the region where lines 720 and 745 intersect. Similarly, the top segments of MR elements $B_l$ and $B_{cl}$ may be placed in the region where lines 725 and 740 intersect, and the bottom segments of MR elements $B_l$ and $B_{cl}$ may be placed in the region where lines 725 and 745 intersect. The top segments of MR elements $B_{cr}$ and $B_r$ may be placed in the region where lines 730 and 740 intersect, and the bottom segments of MR elements $B_{cr}$ and $B_r$ may be placed in the region where lines 730 and 745 intersect. The top segments of MR elements $C_c$ and $C_r$ may be placed in the region where lines 735 and 740 intersect, and the bottom segments of MR elements $C_c$ and $C_r$ may be placed in the region where lines 735 and 745 intersect.

In some embodiments, the locations of regions 710 on substrate 715 may be selected, such that segments of MR elements placed along line 740 sense substantially the same magnetic field amplitude (e.g., bias) in the Y-axis direction, on average, over a period of rotation of a target (e.g., target 14, 301, 401) when the MR elements are biased with a biasing magnet (e.g., magnet 13, 335, 435, 535), and such that segments of MR elements placed along line 745 sense substantially the same magnetic field amplitude (i.e., bias) in the Y-axis direction, on average, over a period of rotation of the target. In some embodiments, the locations of regions 710 on semiconductor die 715 may be selected, such that the segments of MR elements placed in regions 710 sense a magnetic field amplitude (i.e., offset) in the X-axis direction that is close to zero, on average, over a period of rotation of the target. Regions 710 may be selected with reference to a desired placement of a biasing magnet (e.g., magnet 13, magnet 335, magnet 435, magnet 535) not shown in FIG. 7A. For example, the desired placement of the biasing magnet may be such that the center of the magnet and the center of semiconductor die 715 are aligned. Although not shown, other circuitry of a sensor device may also be present on semiconductor die 715, such as signal processing module 14, output module 20, differential amplifier circuit 130, output module 140, amplifier(s) 306, ADC(s) 308, controller(s) 320, one or more memories 324, output interface(s) 355, and/or voltage regulator(s) 326.

FIG. 7B shows another diagram 750 of the example layout of a semiconductor die 715 of FIG. 7A. In the example of FIG. 7B, regions 710 of a semiconductor die 715 correspond to regions for placing segments of magnetic field sensing elements that may satisfy the above-described conditions (i.e., provide substantially the same bias in a Y-axis direction across segments along an axis 740 and along an axis 745, and provide substantially zero offset in an X-axis direction for all segments) for a given magnet (e.g., magnet 13, magnet 335, magnet 435, magnet 535). A Y-axis 755 shows an example distance from a center of substrate 715 (e.g., semiconductor die) in millimeters (mm) in a Y-axis direction, and an X-axis 760 shows an example distance from a center of substrate 715 in millimeters (mm) in an X-axis direction. Each segment of an MR element discussed above may itself be an MR (e.g., GMR, TMR) element (see, e.g., FIG. 2A, 2B and related discussion), and may be fixed in series to a corresponding MR element in a corresponding segment on the other side of the Y=0 axis. In some embodiments, several (or many) MR (e.g., GMR TMR) elements may be placed in each of regions 710, and these MR elements may be coupled in series with corresponding MR elements in a corresponding region on the other side of the Y=0 axis of semiconductor die 715. Placing more MR elements may, for example, increase resolution of the sensor device. Placing more MR elements may also reduce pink noise (i.e., 1/frequency noise) of a sensor device. That is, a sensor device may be susceptible to noise when a rotating target rotates at a low frequency. Using a greater number of MR elements in a region may reduce the noise (i.e., pink noise) when a target rotates at these low frequencies.

As shown in the example of FIG. 7B, the size of regions 710 that satisfy the above-described desired conditions (i.e., provide substantially the same bias in a Y-axis direction across segments along an axis 740 and along an axis 745, and provide substantially zero offset in an X-axis direction for all segments) for magnetic field sensing with a given magnet (e.g., magnet 13, magnet 335, magnet 435, magnet 535) may be limited. As a result, the number of MR elements that may be placed in the regions may be limited. Moreover, as discussed above, it may be desired to align a biasing magnet such that the center of the magnet aligns with the center of the substrate. With some sensor devices, an installer may align and/or package a biasing magnet with a substrate of the sensor device when installing the sensor device in a system, which may lead to increased chances for misalignment or which may require calibration by the installer. Bulk biasing magnets may also be susceptible to changes in characteristics, such as size of the magnet, when a temperature of a system changes. These changes may cause errors in magnetic field sensing by a sensor device when the temperature of a system changes, even when the magnet and sensor device are properly calibrated at a given temperature. Temperature changes of a system may also cause a magnet to crack, which itself may cause errors in magnetic field sensing by a sensor device.

Disclosed are example systems, methods, and structures for improving magnetic field sensor performance. In particular, described are example systems, methods, and structures for improving magnetic field sensor performance in applications where magnetic field sensing elements detect a deflection of a magnetic field generated by a magnet. Systems, methods, and structures disclosed herein may provide a sensor device that includes magnetic field sensing elements and a plurality of magnet structures embedded in a semiconductor die. In some embodiments, the plurality of magnet structures may be configured to generate a magnetic field corresponding to a layout of the magnetic field sensing elements in the semiconductor die. Using systems, methods, and structures disclosed herein, a sensor device may be provided that is less susceptible to misalignment, that has improved resistance to temperature cycling, that has improved resolution, that has improved noise characteristics, that has better immunity to magnetic stray fields, that has less temperature dependence, that is easier to install in a system, that has reduced magnetic offset, and/or that is more compact.

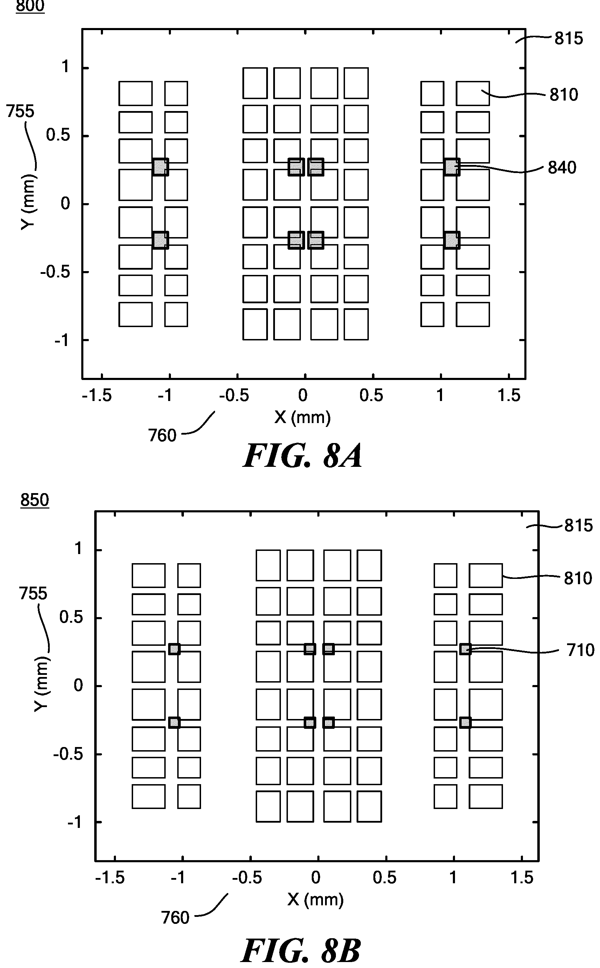

FIG. 8A shows a diagram 800 of an example layout of a substrate 815 (e.g., semiconductor die), consistent with embodiments of the present disclosure. As with FIG. 7B, FIG. 8A includes a Y-axis 755 that shows an example distance from a center of substrate 815 in millimeters (mm) in a Y-axis direction, and an X-axis 760 that shows an example distance from a center of substrate 815 in millimeters (mm) in an X-axis direction.

A biasing magnet may be designed to generate a magnetic field having desired characteristics for substrate 815. For example, as shown in FIG. 8A, a biasing magnet may be constructed from a plurality of magnet structures 810 that together form an overall biasing magnet. A good analogy for operation of the magnet structures can be found in display screen technology. In a display screen, individual pixels act together to form a desired image. Similarly, as shown in FIG. 8A, a plurality of magnet structures 810 may be formed and may act together as an overall biasing magnet to generate a desired magnetic field. As a result, each magnet structure 810 may be referred to as a "pixel" herein, and the overall biasing magnet may be referred to as being "pixelated."

In some embodiments, a front side of a substrate 815 may be used for placing magnetic field sensing elements (e.g., MR elements) and/or other circuitry (e.g., signal processing module 16, output module 20, differential amplifier circuit 130, output module 140, amplifier(s) 306, ADC(s) 308, one or more memories 324, controller(s) 320, output interface(s) 355, voltage regulator(s) 326) of a sensor device. An opposite (i.e., back) side of semiconductor die 815 may be etched with cavities with specific dimensions that may each be filled with a magnet structure 810. That is, magnet structures 810 may be embedded in cavities in the back side of substrate 815. Magnet structures 810 may together act as a biasing magnet that generates a desired magnetic field. In some embodiments, the cavities may be separated by walls of the material (e.g., Silicon) of semiconductor die 815, such that magnet structures 810 are separated by the walls. Magnet structures 810, being smaller than a single bulk biasing magnet, may be less susceptible to changes in characteristics and/or cracking when a temperature of a system varies. Moreover, the walls (e.g., Silicon walls) of the semiconductor die may control thermal expansion of magnet structures 810, limiting size changes of magnet structures 810 as temperature changes in a system.

Regions 840 of semiconductor die 815 may correspond to regions for placing segments of magnetic field sensing elements that may satisfy the above-described desired conditions (i.e., provide substantially the same bias in a Y-axis direction across segments along an axis 740 and along an axis 745, and provide substantially zero offset in an X-axis direction for all segments) for a given magnet. As can be seen by comparing substrate 815 of FIG. 8A with substrate 715 of FIG. 7B, regions 840 of FIG. 8A are larger in area than regions 710 of FIG. 7B. That is, by carefully selecting an appropriate number and appropriate locations and dimensions of magnet structures 810, the magnetic field generated by the combination of magnet structures 810 may serve to increase the size of the regions that satisfy the above-described desired conditions (i.e., provide substantially the same bias in a Y-axis direction across segments along an axis 740 and along an axis 745, and provide substantially zero offset in an X-axis direction for all segments). These larger regions 840 may allow for placement of additional MR (e.g., GMR, TMR) elements, which may provide for improved resolution and/or improved noised characteristics (e.g., improved pink noise characteristics). Additionally, embedding magnet structures 810 in substrate 815 may allow a sensor device constructed on substrate 815 to be less susceptible to misalignment between the biasing magnet and the magnetic field sensing elements and/or may provide for a sensor device that is easier for a user to install, as both the magnetic field sensing elements and the magnet structures of the biasing magnet may be built into the semiconductor die during manufacturing and thus may not need to be aligned during installation of the sensor device in a system.

Embedding a plurality of magnet structures 810 in substrate 815 may also provide for a back-biased sensor device that is more compact than sensor devices with bulk biasing magnets. For example, magnet structures 810 may be embedded in cavities on the opposite side of substrate 815 from magnetic field sensing elements and other sensor device circuitry, and may be embedded such that they are substantially flush with the back side of substrate 815 or extend only slightly beyond the back side of substrate 815. In constructing the sensor device in this fashion, a bulk biasing magnet may not need to be aligned to the backside of substrate 815, thus making the overall sensor device more compact.

Embedding a plurality of magnet structures 810 in substrate 815 may also provide for greater control of the biasing magnetic field on the front side of substrate 815, where the magnetic field sensing elements are placed. For example, as previously discussed, a number and dimensions of magnet structures 810 may be selected to provide for regions 840 for placing magnetic field sensing elements that are larger in size than with conventional bulk biasing magnets. Additionally, a number and dimensions of magnet structures 810 may be selected to improve magnetic field bias and offset characteristics on regions 840 where magnetic field sensing elements are to be placed, which may lead to better immunity to magnetic stray fields and to a reduced dependence of offset to temperature. For example, by selecting the number and dimensions of magnet structures 810, a magnetic field may be generated that provides a bias in a Y-axis direction that is closer to being the same across regions 840 along an axis 740 or axis 745, and that provides an offset in an X-axis direction that is closer to zero across all regions 840.

It should be appreciated that example magnet structures 810 and regions 840 of FIG. 8A are shown as being overlayed to demonstrate how they might align along X and Y axes. However, regions 840 correspond to regions on a front side of a substrate 815 (e.g., semiconductor die), while magnet structures 810 correspond to magnetic material filled in cavities etched onto a back side of substrate 815 opposite the front side. The cavities in which magnet structures 810 are formed may extend a depth into substrate 815 that does not extend all the way through substrate 815.

FIG. 8B shows a diagram 850 of an example layout, showing the regions of a substrate for placing magnetic field sensing elements of FIG. 7B (i.e., regions 710) in comparison to the locations of the magnet structures shown in FIG. 8A (i.e., magnet structures 810). As just discussed with respect to FIG. 8A, the regions in which MR elements may be placed given such a biasing magnet design may be larger than regions 710 (see regions 840 of FIG. 8A). FIG. 8B is merely provided so that differences in sizes of regions 710 and 840 may be compared with respect to the same biasing magnet design. As can be seen by comparing regions 840 of FIG. 8A with regions 710 of FIG. 8B, regions 840 of FIG. 8A are significantly larger than regions 710 of FIG. 7B, due to the selection of the number and dimensions of magnet structures 810 embedded in substrate 815. For example, regions 840 of FIG. 8A may be 3.5 times larger than regions 710 of FIG. 7B. As previously discussed, the larger regions (e.g., regions 840) may allow for placement of more MR (e.g., GMR, TMR) elements, which may help to reduce pink noise. For example, filling regions 840 with MR elements may provide for a sensor device where pink noise is reduced 1.9 times from a sensor device where smaller regions 710 are filled with MR elements. Such a reduction in pink noise may also be beneficial in sensor devices utilizing TMR elements, which may tend to have 10 times more pink noise than sensor devices utilizing GMR elements in the same semiconductor die footprint.

Although particular numbers, locations, and sizes of regions 840 are shown for an example substrate 815 in FIG. 8A, the disclosure is not so limited. For example, it may be desired to provide any number of regions for placing MR elements, or regions of any of a number of different dimensions. The disclosure should not be limited to the example shown in FIG. 8A. Similarly, although particular numbers, locations, and sizes of magnet structures 810 are shown for an example substrate 815 in FIG. 8A, the disclosure is not so limited. For example, it may be desired to provide any number of different magnet structures, or magnet structures in any of a number of different dimensions, on one side of a substrate, to generate a desired magnetic field for desired regions on an opposing side of the substrate. The disclosure should not be limited to the example shown in FIG. 8A.

Substrate 815 may be a Silicon substrate (e.g., semiconductor die), such as Silicon wafer or a portion of a Silicon wafer that may typically be used in manufacturing integrated circuits (ICs) or semiconductors. However, the disclosure is not so limited. Substrate 815 may be made of glass, or plastic, as just some other examples. A person of ordinary skill in the art would recognize that a variety of different materials could be used as a substrate, and the disclosure herein should be considered to include any of these alternative materials.

Magnet structures (e.g., magnet structures 810) may be formed in a side of a substrate (e.g., substrate 815) opposite a side on which magnetic field sensing elements and other circuitry associated with the sensor device may be placed. To form the magnet structures, a desired layout for the magnet structures may first be developed. For example, test chips may be tested and/or simulations may be run to determine a layout for the biasing magnet that produces a desired magnetic field. The layout may include a number of magnet structures to include, locations of the magnet structures, and/or dimensions of each of the magnet structures, that generate a desired magnetic field. The desired magnetic field may be a magnetic field that, for example, satisfies the above-described desired conditions (i.e., provide substantially the same bias in a Y-axis direction across segments along an axis 740 and along an axis 745, and provide substantially zero offset in an X-axis direction for all segments) for regions of a particular size on an opposite side of a substrate from the magnet structures. Factors such as a material of the magnet structures, material of the substrate, dimensions of the substrate, type of magnetic field sensing element, type of target, and/or air gap between the magnetic field sensing elements and the target, may also be considered in running tests and/or simulations to determine an appropriate magnet layout for generating a desired magnetic field.

Once a desired layout has been determined, a mask template may be generated that corresponds to the layout. The mask template may then be used to etch cavities in the substrate that are the same in number, location, and/or dimensions as the magnet structures desired to be formed in the substrate. Known etching techniques, such as layering a substrate with a mask material in patterns corresponding to the desired cavities, may be used to etch the cavities. For example, photolithography may be used to etch the cavities, as one example. As additional examples, reactive ion etching (RIE) or deep reactive ion etching (DRIE) may be used to etch the cavities.

Once the cavities have been formed, the cavities may be filled with a powder of magnetic material. The powder may be any type of magnetic material, or a combination of different types of magnetic material. As one example, the powder may be NdFeB powder. The powder may also be Fe or NiFe or SmCo, as just some examples. Once the cavities are filled with the powder of magnetic material, the powder in each cavity may be solidified together using atomic layer deposition, thereby forming each of the magnet structures and embedding each of the magnet structures in its respective cavity in the substrate. Further discussion of techniques that may be used for forming the magnet structures are further discussed in "A Novel Fabrication Technique for MEMS Based on Agglomeration of Powder by ALD," Journal of Microelectromechanical Systems, Vol. 26, No. 5, October 2017, in "Fully Integrated Back-Biased 3D Hall Sensor with Wafer-level Integrated Permanent Micromagnets," IEEE MEMS 2023, in "Demonstration of Fully Integrable Long-Range Microposition Detection with Wafer-Level Embedded Micromagnets," Micromachines 2022, in "Investigation of Wafer-Level Fabricated Permanent Micromagnets for MEMS," Micromachines 2022, in "PowderMEMS - A Generic Microfabrication Technology for Integrated Three-Dimensional Functional Microstructures," Micromachines 2022, in U.S. Patent No. 9,221,217 entitled "Method for Producing a Three-Dimensional Structure and Three-Dimensional Structure," and in U.S. Patent Application Publication No. 2024/0065109 entitled "Method for Manufacturing a Magnetic Field Sensor Chip with an Integrated Back-Bias Magnet," all of which are herein incorporated by reference in their entireties. Once the magnet structures have been embedded in the cavities, the magnet structures may be magnetized, such as by passing by coils that serve to magnetize the magnet structures.

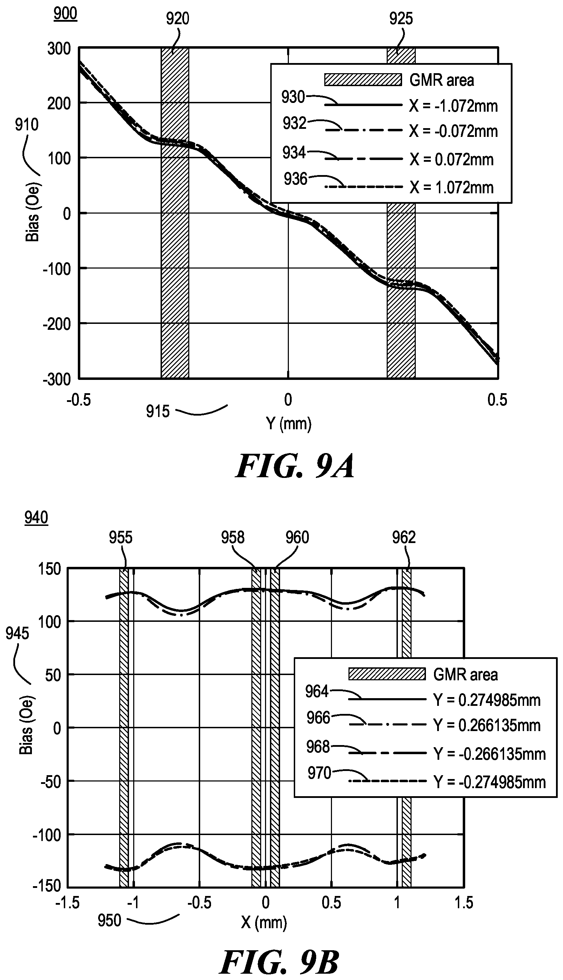

FIG. 9A is a graph 900 showing simulated plots of magnetic field biases in a Y-axis direction generated by the layout of magnet structures 810 of FIG. 8A at different locations of substrate 815. Graph 900 includes a Y-axis 910 showing the bias in Oersted (Oe) in a Y-axis direction (see FIG. 8A) of substrate 815, and an X-axis 915 showing a distance from a center of substrate 815 along the Y-axis (see FIG. 8A) of substrate 815. Plots 930, 932, 934, and 936 correspond to strengths of magnetic biases in the Y-axis direction at different positions along the Y-axis of substrate 815 at X-axis locations corresponding to axes 720, 725, 730, 735 of FIG. 7A, over a period of rotation of a target. For example, plot 930 shows simulated strengths of magnetic biases in the Y-axis direction at different positions along the Y-axis of substrate 815 at a position along the X-axis of substrate 815 of -1.072 mm (e.g., corresponding to axis 720 of FIG. 7A). Plot 932 shows simulated strengths of magnetic biases in the Y-axis direction at different positions along the Y-axis of substrate 815 at a position along the X-axis of substrate 815 of -0.072 mm (e.g., corresponding to axis 725 of FIG. 7A). Plot 934 shows simulated strengths of magnetic biases in the Y-axis direction at different positions along the Y-axis of substrate 815 at a position along the X-axis of substrate 815 of 0.072 mm (e.g., corresponding to axis 730 of FIG. 7A). Plot 936 shows simulated strengths of magnetic biases in the Y-axis direction at different positions along the Y-axis of substrate 815 at a position along the X-axis of substrate 815 of 1.072 mm (e.g., corresponding to axis 735 of FIG. 7A).

As shown in graph 900, regions above the Y=0 axis experience a positive magnetic field bias in the Y-axis direction, and regions below the Y=0 axis experience a negative magnetic field bias in the Y-axis direction. As previously discussed, segments of magnetic field sensing elements may be placed on both sides of the Y=0 axis, such that the biases offset for any misalignment of the biasing magnet with respect to the magnetic field sensing elements.

As also shown in graph 900, at the given positions along the X-axis of substrate 815, there are certain positions along the Y-axis of substrate 815 over which the bias in the Y-axis direction remains substantially constant. These positions are shown in grey in 920 and 925 of graph 900. These positions correspond to regions (e.g., regions 840) in which it may be desired to place magnetic field sensing elements.

FIG. 9B is another graph 940 showing simulated plots of magnetic field biases in a Y-axis direction generated by the layout of magnet structures 810 of FIG. 8A at different locations of substrate 815. Graph 940 includes a Y-axis 945 showing the bias in Oersted (Oe) in a Y-axis direction (see FIG. 8A) of substrate 815, and an X-axis 950 showing a distance from a center of substrate 815 along the X-axis (see FIG. 8A) of substrate 815. Plots 964, 966, 968, and 970 correspond to strengths of magnetic biases in the Y-axis direction at different positions along the X-axis of substrate 815 at Y-axis locations corresponding to axes 740 and 745 of FIG. 7A, over a period of rotation of a target. Although only horizontal axes 740, 745 are shown in FIG. 7A, the two top regions 710 along axes 725, 730 of FIG. 7A are actually slightly below axis 740, and the two bottom regions 710 along axes 725, 730 of FIG. 7A are actually slightly above axes 745, which is why four plots along the Y-axis of substrate 815 are shown in graph 940. For example, plot 964 shows simulated strengths of magnetic biases in the Y-axis direction at different positions along the X-axis of substrate 815 at a position along the Y-axis of substrate 815 of 0.274985 mm (corresponding to axis 740 of FIG. 7A). Plot 966 shows simulated strengths of magnetic biases in the Y-axis direction at different positions along the X-axis of substrate 815 at a position along the Y-axis of substrate 815 of 0.266135 mm (corresponding to an axis slightly below axis 740 of FIG. 7A). Plot 968 shows simulated strengths of magnetic biases in the Y-axis direction at different positions along the X-axis of substrate 815 at a position along the Y-axis of substrate 815 of -0.266135 mm (corresponding to an axis slightly above axis 745 of FIG. 7A). Plot 970 shows simulated strengths of magnetic biases in the Y-axis direction at different positions along the X-axis of substrate 815 at a position along the Y-axis of substrate 815 of -0.274985 mm (corresponding to axis 745 of FIG. 7A).

As shown in graph 940, regions above the Y=0 axis experience a positive magnetic field bias in the Y-axis direction, and regions below the Y=0 axis experience a negative magnetic field bias in the Y-axis direction. As previously discussed, segments of magnetic field sensing elements may be placed on both sides of the Y=0 axis, such that the biases offset for any misalignment of the biasing magnet with respect to the magnetic field sensing elements.

As also shown in graph 940, at the given positions along the Y-axis of substrate 815, there are certain positions along the X-axis of substrate 815 at which the bias in the Y-axis direction is substantially constant. These positions are shown in grey in 955, 958, 960, and 962 of graph 940. As shown in graph 940, regions at these positions experience substantially the same bias in the Y-axis direction. These positions correspond to regions (e.g., regions 840) in which it may be desired to place magnetic field sensing elements.

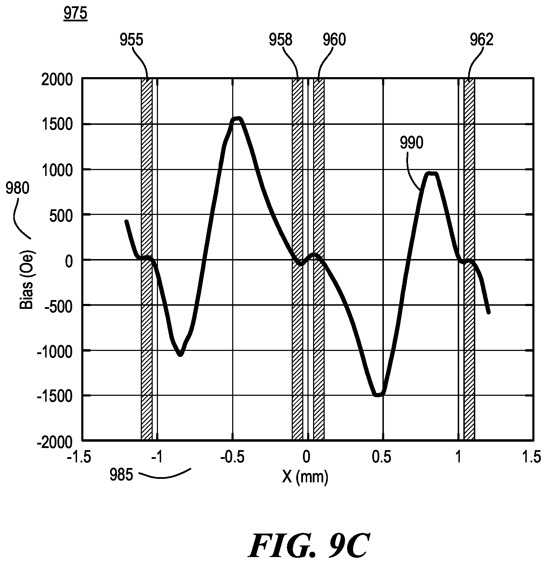

FIG. 9C is a graph 975 showing simulated plots of magnetic field offsets in an X-axis direction generated by the layout of magnet structures 810 of FIG. 8A at different locations of substrate 815. Graph 975 includes a Y-axis 980 showing in the offset in Oersted (Oe) in an X-axis direction (see FIG. 8A) of substrate 815, and an X-axis 985 showing a distance from a center of substrate 815 along the X-axis (see FIG. 8A) of substrate 815. Plot 990 corresponds to simulated strengths of magnetic offset in the X-axis direction at different positions along the X-axis of substrate 815, over a period of rotation of a target. As previously discussed, the magnetic field sensing elements placed in regions 840 may be oriented so as to be maximally sensitive to a magnetic field in the X-axis direction (see FIG. 8A). As a result, it may be desired that the magnetic offset in the regions where the magnetic field sensing elements are to be placed be as close to zero as possible. Positions 955, 958, 960, 962 shown in grey in graph 975 correspond to regions 840 along the X-axis of substrate 815 where magnetic field sensing elements are to be placed. As shown in FIG. 9C, the offset in these regions, on average over a period of rotation of a target, is relatively flat and substantially zero Oe.

The layout of magnet structures 810 and regions 840 of FIG. 8A is just one example layout for a possible sensor device. FIGs. 9A-9C serve to illustrate that a plurality of magnet structures (e.g., magnet structures 810) and regions (e.g., regions 840) for placing magnetic field sensing devices may be laid out on a substrate (e.g., substrate 815) in a manner such a magnetic field bias is substantially constant among the regions and such that a magnetic offset in the regions is substantially zero. FIGs. 8A and 9A-9C also serve to illustrate that these conditions may be satisfied while making regions (e.g., regions 840) larger, allowing for placement of additional magnetic field sensing elements and thereby improving resolution and reducing pink noise. However, the disclosure should not be limited to the example layout of FIG. 8A. Any number of magnet structures in any locations and of any of a variety of different dimensions may be utilized to generate desired magnetic fields for biasing certain regions of a substrate. Similarly, any number of regions in any locations and of any of a variety of different dimensions may be desired for placing magnetic field sensing elements, and different configurations of a plurality of magnet structures may be utilized for generating a magnetic field for biasing such regions. Moreover, some of the plurality of magnet structures (and their associated cavities) may have dimensions (and associated volumes) that differ from others of the plurality of magnet structures in order to generate a desired magnetic field. Similarly, certain regions for placing magnetic field sensing elements may have dimensions that differ from others of the regions. Different combinations of magnetic materials may also be used in the powder used to construct the magnet structures in order to generate a desired magnetic field. In general, a plurality of different magnet structures may be embedded in a substrate in selected numbers, at selected locations, of selected dimensions, and of selected compositions, so as to generate (or shape) a magnetic field for a particular application. Indeed, the example shown in FIG. 8A illustrates that, for its particular application, certain magnet structures 810 are wider along the X-axis than other magnet structures 810, and certain magnet structures 810 are taller along the Y-axis than other magnet structures 810, so as to generate the desired magnetic field for biasing regions 840.

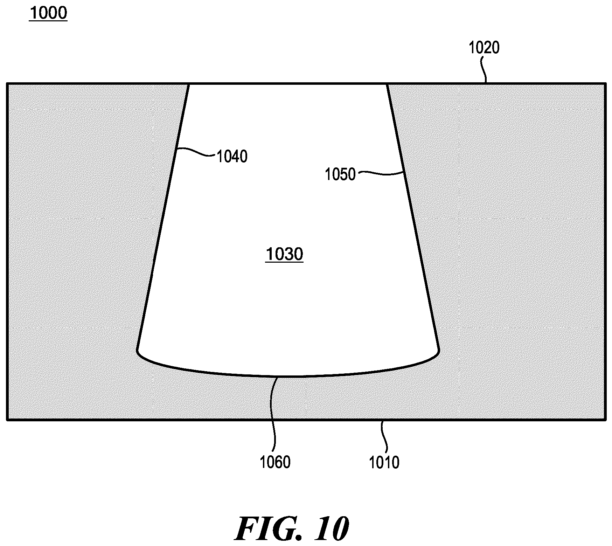

FIG. 10 shows a diagram 1000 of an example cavity 1030 that may be etched into a substrate (e.g., substrate 815) for embedding a magnet structure (e.g., magnet structure 810), consistent with embodiments of the present disclosure. Example cavity 1030 may be utilized for all cavities in which magnet structures (e.g., magnet structures 810) are placed, or for only certain cavities in which the magnet structures will be placed. Use of the cavity structure shown in FIG. 10 may help to control the magnetic field (or field map) generated on the surface of the substrate where magnetic field sensing elements (e.g., GMR, TMR elements) are to be placed. For example, surface 1010 may correspond to a first surface of a substrate (e.g., substrate 815) on which magnetic field sensing elements are to be placed. Surface 1020 may correspond to a second, opposing surface of the substrate in which the cavities (e.g., cavity 1030) will be etched and the magnet structures (e.g., magnet structures 810) embedded. As shown in FIG. 10, a cavity may be etched so as to have an undercut. For example, surface 1040 of cavity 1030 may be undercut such that an angle between surface 1040 and an opening of the cavity along surface 1020 is greater than 90 degrees. Similarly, surface 1050 of cavity 1030 may be undercut such that an angle between a surface 1050 and an opening of the cavity along surface 1020 is greater than 90 degrees. However, the disclosure is not so limited. In some embodiments, cavity 1030 may be formed such that one or more surfaces of cavity 1030 form an angle with an opening of the cavity along surface 1020 that ranges between 0 and 10 degrees from 90 degrees (e.g., 90° ± 10°). Providing such an undercut may help to smooth out the gradient of the magnetic bias and/or magnetic offset in regions (e.g., regions 840) of a substrate where magnetic field sensing elements are placed. Such smoothing may increase the size of the regions (e.g., regions 840) in which magnetic field sensing elements may be placed.

As shown in the example of FIG. 10, a bottom of a cavity (e.g., cavity 1030) may be formed so as to have an arced surface 1060. However, the disclosure is not so limited, and the bottom of a cavity may be formed to have any shape.

It should be recognized that the cavities for embedding magnet structures discussed herein should not be limited to the example cavity 1030 shown in FIG. 10. A cavity may take any shape or form, with any of a variety of dimensions, to achieve the desired magnetic field for a particular application. Moreover, combinations of cavities of different shapes and/or dimensions may be used together to achieve a desired magnetic field. Any such configurations should be considered to be within the scope of the disclosure herein.

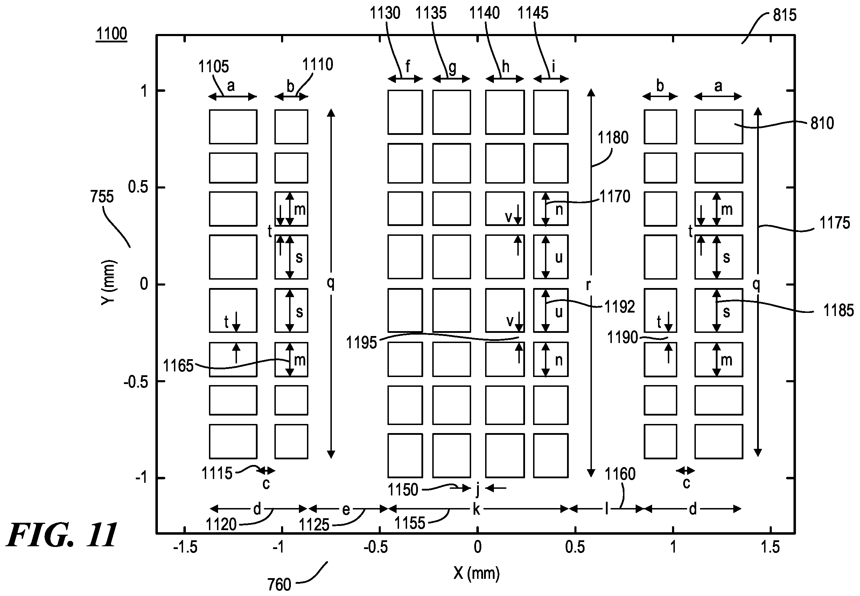

FIG. 11 shows a diagram 1100 of an example layout of a substrate 815 (e.g., semiconductor die) with example parameters that may be adjusted for magnet structures in designing an overall biasing magnet for a sensor device, consistent with embodiments of the present disclosure. That is, as previously discussed, various numbers, locations, and/or dimensions of magnet structures may be adjusted to design a biasing magnet for one side of a substrate that generates a desired magnetic field for regions on an opposite side of the substrate where magnetic field sensing elements are placed.

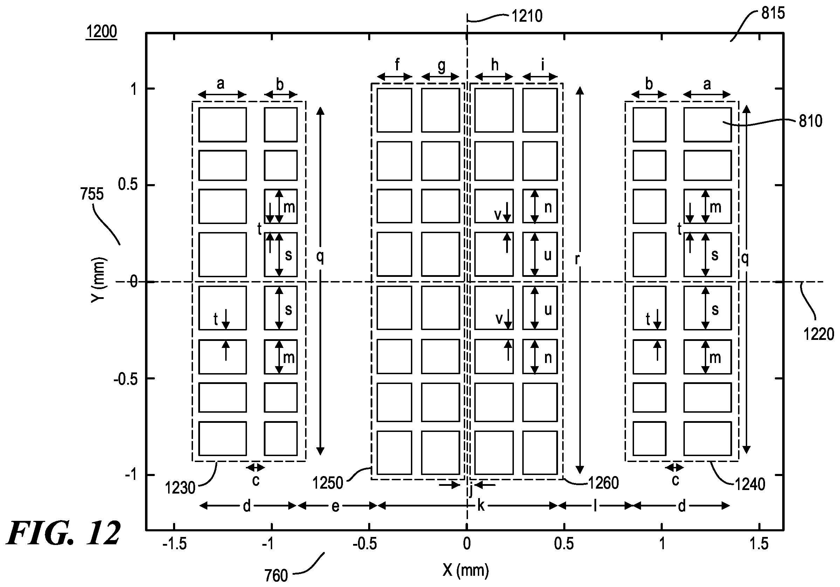

As shown in the example layout of FIG. 11, the magnet structures may be arranged into three groups that roughly correspond to regions on an opposite side of the substrate where magnetic field sensing elements are placed. As shown in the example layout, the magnet structures may be arranged into three groups, a left group 1230 (see FIG. 12), a central group (comprising 1250 and 1260 of FIG. 12), and a right group 1240 (see FIG. 12). Each group may include columns and rows of magnet structures.

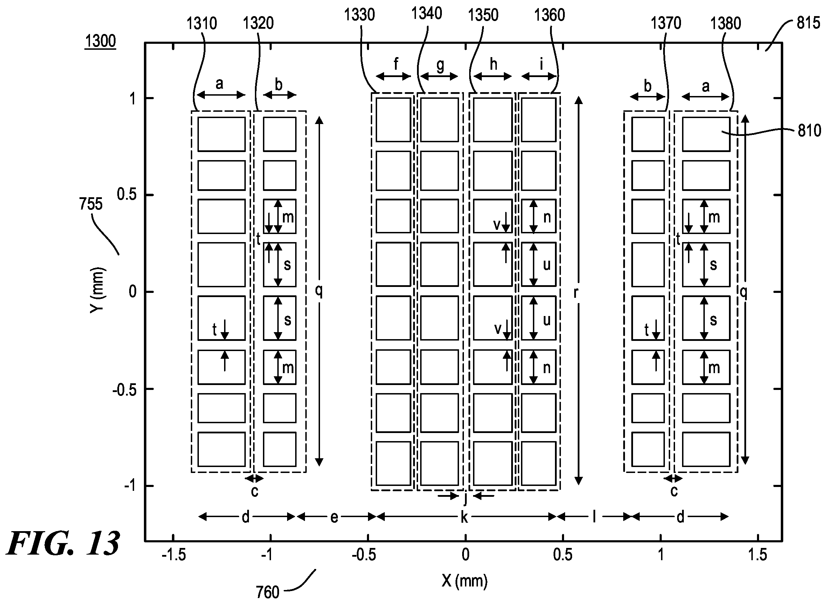

One parameter that may be adjusted to achieve an overall desired magnetic biasing field is parameter "a" 1105, which corresponds to a width along the X-axis of the magnet structures in the outermost columns (corresponding to columns 1310, 1380 as shown in FIG. 13) of the overall magnet design. Another parameter that may be adjusted is parameter "b" 1110, which corresponds to a width along the X-axis of the magnet structures in the other columns (corresponding to columns 1320, 1370 as shown in FIG. 13) of left group 1230 and of right group 1240. A parameter "c" 1115 may also be adjusted. Parameter "c" 1115 may correspond to a width along the X-axis of the substrate (e.g., Silicon) walls between the columns of magnet structures in left group 1230 and in right group 1240. A parameter "d" 1120 may also be adjusted. Parameter "d" 1120 may correspond to an overall width along the X-axis of left group 1230 and of right group 1240.

A parameter "e" 1125 may also be adjusted. Parameter "e" 1125 may correspond to a width along the X-axis of the substrate (e.g., Silicon) walls between left group 1230 and central group 1250. Similarly, a parameter "l" 1160 may be adjusted that corresponds to a width along the X-axis of the substrate (e.g., Silicon) walls between right group 1240 and central group 1260.

A parameter "f" 1130 may also be adjusted. Parameter "f" 1130 may correspond to a width along the X-axis of the magnet structures in a leftmost column (corresponding to column 1330 as shown in FIG. 13) of central group 1250. Similarly, a parameter "i" 1145 may be adjusted that corresponds to a width along the X-axis of the magnet structures in a rightmost column (corresponding to column 1360 as shown in FIG. 13) of central group 1260.

A parameter "g" 1135 may also be adjusted. Parameter "g" 1135 may correspond to a width along the X-axis of the magnet structures in left central column (corresponding to column 1340 of FIG. 13) of central group 1250. Similarly, a parameter "h" 1140 may be adjusted that corresponds to a width along the X-axis of the magnet structures in a right central column (corresponding to column 1350 of FIG. 13) of central group 1260.

A parameter "j" 1150 may also be adjusted. Parameter "j" 1150 may correspond to a width along the X-axis of the substrate (e.g., Silicon) walls between central groups 1250 and 1260 (or between columns 1340 and 1350).

A parameter "k" 1155 may also be adjusted. Parameter "k" 1155 may correspond to an overall width along the X-axis of central group 1250, 1260.

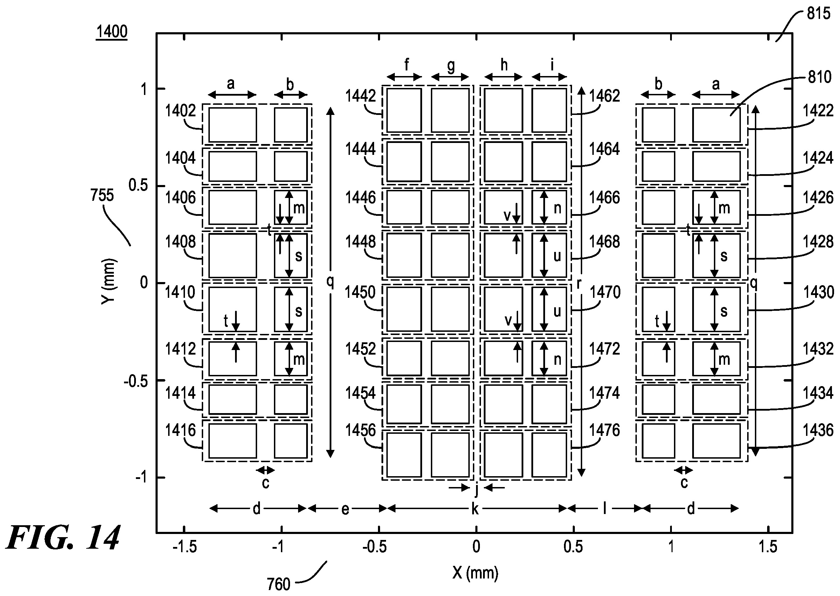

A parameter "m" 1165 may also be adjusted. Parameter "m" 1165 may correspond to a height along the Y-axis of certain rows (corresponding to rows 1406, 1412, 1426, 1432 of FIG. 14) of left group 1230 and of right group 1240.

A parameter "n" 1170 may also be adjusted. Parameter "n" 1170 may correspond to a height along the Y-axis of certain rows (corresponding to rows 1446, 1452, 1466, 1472) of central groups 1250, 1260.

A parameter "q" 1175 may also be adjusted. Parameter "q" 1175 may correspond to an overall height along the Y-axis of left group 1230 and of right group 1240.

A parameter "r" 1180 may also be adjusted. Parameter "r" 1180 may correspond to an overall height along the Y-axis of central groups 1250, 1260.

A parameter "s" 1185 may also be adjusted. Parameter "s" 1185 may correspond to a height along the Y-axis of the magnet structures in certain rows (corresponding to rows 1408, 1410, 1428, 1430) of left group 1230 and of right group 1240.

A parameter "t' 1190 may also be adjusted. Parameter "t" 1190 may correspond to a height along the Y-axis of the substrate (e.g., Silicon) walls between first rows (corresponding to rows 1406 and 1408) and between second rows (corresponding to rows 1410 and 1412) of left group 1230, and between first rows (corresponding to rows 1426 and 1428) and between second rows (corresponding to rows 1430 and 1432) of right group 1240.

A parameter "u" 1192 may also be adjusted. Parameter "u" 1192 may correspond to a height along the Y-axis of magnet structures in certain rows (corresponding to rows 1448, 1450, 1468, 1470) of central groups 1250, 1260.

A parameter "v" 1195 may also be adjusted. Parameter "v" 1195 may correspond to a height along the Y-axis of the substrate (e.g., Silicon) walls between first rows (corresponding to rows 1446 and 1448), between second rows (corresponding to rows 1450 and 1452), between third rows (corresponding to rows 1466 and 1468), and between fourth rows (corresponding to rows 1470 and 1472) of central groups 1250, 1260.

As just one example, by controlling the above parameters, an overall biasing magnet comprised of a plurality of magnet structures may be designed for one side of a substrate that will generate a desired magnetic biasing field on certain regions of an opposite side of the substrate. For example, the gradient of a magnetic bias in the Y-axis direction may be made approximately zero along a Y-axis of the substrate in regions where magnetic field sensing elements are placed (see FIG. 9A) by balancing the dimensions of parameters "m," "s," "u," and "n" discussed above versus dimensions of parameters "v" and "t" discussed above. As another example, the gradient of a magnetic bias in the Y-axis direction may be made approximately zero along an X-axis of the substrate in regions where magnetic field sensing elements are placed (see FIG. 9B) by balancing the dimensions of parameters "a," "b," "g," and "h" discussed above versus dimensions of parameters "c" and "j" discussed above. As an additional example, a bias in the Y-axis direction on an outer edge of the substrate and in a center of the substrate may be substantially equalized by tuning dimensions of parameters "r" and "q" discussed above. As one more example, an offset in the X-axis direction may be made approximately zero regions where magnetic field sensing elements are placed (see FIG. 9C) by tuning dimensions of parameters "a," "b," "e," "f," "g," "h," "i," and "l" discussed above versus dimensions of parameters "d" and "k" discussed above.

Adjusting a width and height of a cavity may have tradeoffs. For example, reducing a width and/or height of a cavity may result in a magnet structure that is small enough to limit its thermal expansion under temperature variations, but may reduce the amount of magnet powder that may be filled into the cavity. By contrast, expanding a width and/or height of a cavity may allow more magnet powder to be filled into the cavity such that the magnet structure is greater in volume, but may make the magnet structure more susceptible to thermal expansion under temperature variations.

Although certain example parameters for tuning the overall biasing magnet are provided above, the disclosure is not limited to these parameters, and any number of other parameters may be adjusted to achieve an overall desired biasing magnetic field. As just one example, a depth of the cavities in which the magnetic structures are placed may be adjusted, such that some cavities may be deeper than other cavities in a particular desired layout. Additionally, the magnet structures should not be limited to the substantially square or rectangular shapes shown in FIGs. 8A, 8B, and 11-14. Cavities and corresponding magnet structures may be made in any shape, such as in cylinders, pyramids, cones, spheres, or any other shape that produces a desired magnetic field for biasing regions of a substrate.

FIG. 12 shows a diagram 1200 of the example layout of a substrate 815 (e.g., semiconductor die) previously discussed with respect to FIGs. 8A, 8B, and 11. As shown in FIG. 12, in some embodiments a layout of the overall biasing magnet structure, comprised of a plurality of magnet structures, may be symmetrical about an axis 1210 and about an axis 1220. Magnet structures may be considered to be grouped into three different groups, a left group 1230, a right group 1240, and central group 1250, 1260. The central group may comprise two central groups, a left central group 1250 and a right central group 1260. As shown in FIG. 8A, the groups may correspond to regions on an opposite side of the substrate where magnetic field sensing elements are placed.

FIG. 13 shows a diagram 1300 of the example layout of a substrate 815 (e.g., semiconductor die) previously discussed with respect to FIGs. 8A, 8B, 11, and 12. As shown in FIG. 13, in some embodiments a layout of the overall biasing magnet structure, comprised of a plurality of magnet structures, may be considered to be grouped into eight different columns, columns 1310, 1320, 1330, 1340, 1350, 1360, 1370, and 1380.

FIG. 14 shows a diagram 1400 of the example layout of a substrate 815 (e.g., semiconductor die) previously discussed with respect to FIGs. 8A, 8B, 11, 12, and 13. As shown in FIG. 14, in some embodiments a layout of the overall biasing magnet structure, comprised of a plurality of magnet structures, may be considered to be grouped into thirty-two different rows, rows 1402, 1404, 1406, 1408, 1410, 1412, 1414, 1416, 1422, 1424, 1426, 1428, 1430, 1432, 1434, 1436, 1442, 1444, 1446, 1448, 1450, 1452, 1454, 1456, 1462, 1464, 1466, 1468, 1470, 1472, 1474, and 1476.

As previously discussed, any number of magnet structures of any of a variety of different dimensions may be used to generate a magnetic field for biasing regions for placing magnetic field sensing elements. As also previously discussed, different numbers, locations, and/or dimensions of regions may be provided to place magnetic field sensing elements, the selection of which may depend on the particular application in which a sensor device is to be used.

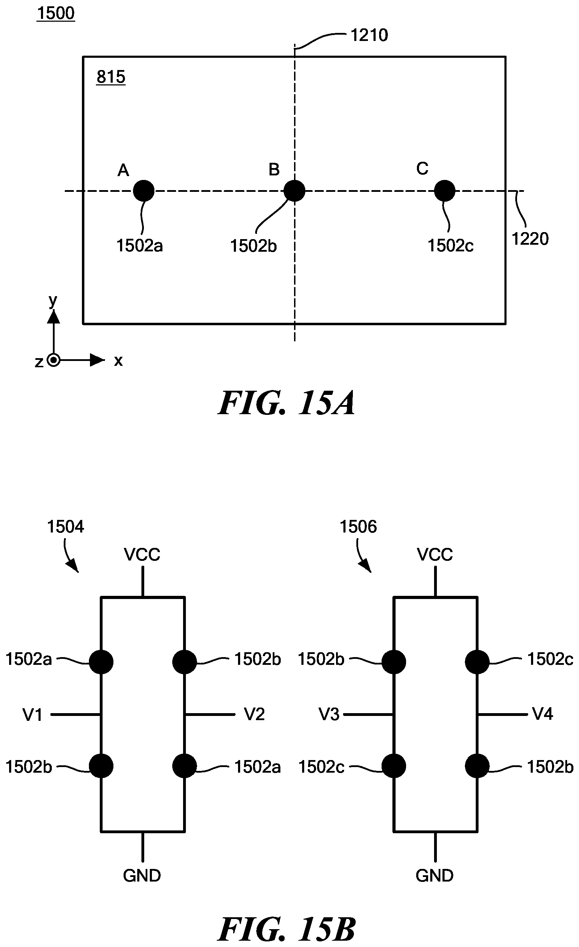

FIG. 15A shows a diagram 1500 of another example layout of a substrate 815 (e.g., semiconductor die) with regions A 1502a, B 1502b, and C 1502c in different locations than in FIG. 7A. The layout shown in FIG. 15A is a layout that may be used for placing a particular type of TMR magnetic field sensing element that has a vortex layer, referred to herein as a TMR vortex element.

A TMR vortex element may be formed as a pillar (see, e.g., FIG. 2B) that includes a free layer (e.g., free layer(s) 275) with a magnetic vortex. The magnetic vortex may have magnetization directions that loop around free layer(s) 275, and free layer(s) 275 may be provided as a magnetic disk. The magnetic vortex may have a core, and close to the center of the core the magnetization directions may start to become more and more nonplanar. A TMR vortex magnetic field sensing element may have a sensitivity that is set by a ratio of the thickness of the free layer (e.g., free layer(s) 275) to the diameter of the vortex. As a result, in contrast to certain other types of magnetic field sensing elements, such as typical GMR or TMR elements, a magnetic back bias field may not be needed to tune the sensitivity of TMR vortex magnetic field sensing elements. In some embodiments, use of TMR vortex magnetic field sensing elements may make it possible to manufacture sensor devices that have a reduced footprint and that have increased signal-to-noise ratio (SNR). Additional details regarding the construction and use of TMR vortex magnetic field sensing elements is provided in U.S. Patent Application Publication No. 2023/0332878, entitled "Angle Sensor with a Single Die Using a Single Target," which is hereby incorporated by reference in its entirety.

The example layout in FIG. 15A may be used to place TMR vortex elements in regions A 1502a, B 1502b, and C 1502c. The TMR elements may be formed as pillars comprising a stack of layers (e.g., a stack of layers similar to that shown in FIG. 2B) and having magnetic vortex cores. In some embodiments, multiple TMR vortex elements may be placed in each of regions A 1502a, B 1502b, and C 1502c. The TMR vortex elements may be laid out in regions A 1502a, B 1502b, and C 1502c along a common line corresponding to a horizontal symmetry axis 1220 (which may correspond to axis 1220) of a back bias magnet (e.g., biasing magnet structure formed by a plurality of magnet structures such as shown in FIGs. 8A, 8B, and 11-14). In some embodiments, region B 1502b may be placed along a vertical symmetry axis 1210 (which may correspond to axis 1210) of a back bias magnet (e.g., biasing magnet structure formed by a plurality of magnet structures such as shown in FIGs. 8A, 8B, and 11-14). In some embodiments regions A 1502a and C 1502c may be equidistant from region B 1502B.

FIG. 15B shows circuit representations of example bridges formed from the magnetic field sensing elements of FIG. 15A. The TMR vortex elements within regions A 1502a, B 1502b, and C 1502c may be connected to form bridge circuits, such as the two bridge circuits 1504 and 1506 shown in FIG. 15B. Bridge circuit 1504 may be a left bridge formed using TMR vortex elements in region A 1502a along one diagonal and TMR vortex elements in region B 1502b along another diagonal. On one side of bridge circuit 1504, TMR vortex elements from region A 1502a and from region B 1502b may be connected in series between a power supply voltage (e.g., $V_{CC}$) and a ground potential (GND), with a first output terminal V1 located therebetween. On the other side of bridge 1504, TMR vortex elements from region B 1502b and from region A 1502a may be connected in series between the power supply voltage and the ground potential, with a second output terminal V2 located therebetween.

The other bridge circuit 1506 may be a right bridge formed using TMR vortex elements from region B 1502b along one diagonal and TMR vortex elements from region C 1502c along another diagonal. On one side of bridge circuit 1506, TMR vortex elements from region B 1502b and from region C 1502c may be connected in series between the power supply and the ground potential, with a third output terminal V3 located therebetween. On the other side of bridge circuit 1506, TMR vortex elements from region C 1502 and from region B 1502b may be connected in series between the power supply and the ground potential, with a fourth output terminal V4 located therebetween.

In some embodiments, magnetic field signals output by bridges 1504 and 1506 using the TMR vortex layout of FIG. 15A may be functionally equivalent to the magnetic field signals output by bridges (e.g., bridges 630, 650) provided by the layout of FIGs. 6 and 6A.

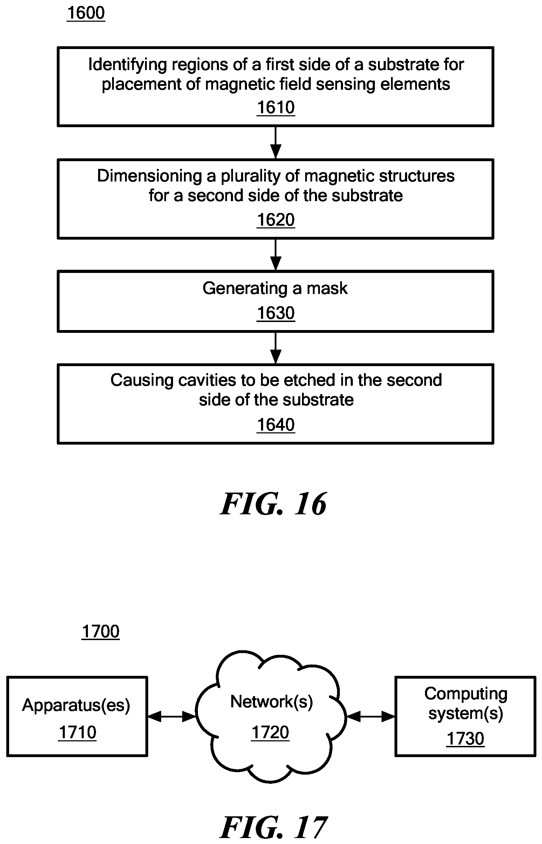

FIG. 16 shows an example process 1600 for configuring a layout of magnet structures and causing cavities in a semiconductor die to be etched according to the layout, consistent with embodiments of the present disclosure. Process 1600 may be performed, for example, in an environment (e.g., environment 1700), such as an environment in which integrated circuits (ICs) or semiconductor devices, such as magnetic field sensing devices, are manufactured.

In 1610, regions of a first side of a substrate for placement of magnetic field sensing elements may be identified. The magnetic field sensing elements may be any of the types of magnetic field sensing elements previously discussed. In some embodiments, the magnetic field sensing elements may be GMR elements, TMR elements, TMR vortex elements and/or Hall plates. The regions may be any regions of any particular number, location, and/or dimensions for manufacturing a sensor device, the selection of which may depend on the application for a particular sensor device. In some embodiments, the regions may be regions 840 of FIG. 8A, or regions A 1502a, B 1502b, and C 1502c of FIG. 15A. In some embodiments, the regions may be identified as a result of running tests and/or simulations, such as on computing device (e.g., computing device 1810). In some embodiments, the regions may have been previously identified as a result of simulations and/or tests, and may be identified in 1610 in a computing device (e.g., computing device 1810) from a stored layout template used in placing magnetic field sensing elements in the regions for a particular sensor device product. In some embodiments, the substrate may be sub strate 815.

In 1620, a plurality of magnet structures may be dimensioned for a second side of the substrate. For example, tests and/or simulations may be run in a computing device (e.g., computing device 1810), and parameters (e.g., parameters of FIG. 11) corresponding to numbers, locations, and/or dimensions of magnet structures and/or walls of substrate material may be varied to determine a layout of magnet structures that generate a desired magnetic field for biasing regions on the first side of the substrate on which magnetic field sensing elements are placed.

In 1630, once an appropriate layout of magnet structures for the second side of the substrate has been created, a mask may be developed. The mask may be a template that corresponds to the layout of the magnet structures. The mask may be stored and reused for embedding magnet structures in a second side of a substrate that correspond to the layout. For example, when manufacturing the same product (where the layout of the magnetic field sensing elements and other sensor device circuitry remains the same), the same mask may be reused to generate the same overall biasing magnet (comprised of a plurality of embedded magnet structures) for each of the products. Additional masks may be generated for other products requiring a different magnet layout. In some embodiments, the mask may be generated by and/or stored in a computing device (e.g., computing device 1810).

In 1640, a device may cause cavities to be etched in the second side of the substrate. For example, a computing device (e.g., computing device 1810) of a computing system (computing system(s) 1730) may send a mask, or instructions based on a mask, over one or more networks 1720 to apparatus(es) 1710. Apparatus(es) 1710 may include one or more apparatuses for etching the second side of the substrate. For example, in some embodiments, one or more layers of material may be deposited on the second side of the substrate in a pattern corresponding to the mask, and a machine may etch the cavities in which the magnet structures will be embedded based on the pattern. In some embodiments, a reactive ion etching (RIE) or deep reactive ion etching (DRIE) techniques may be used to etch the cavities in which the magnet structures will be embedded. Any known technique for etching features on a substrate may be used, and apparatus(es) 1710 may include any known apparatus for performing any of these known techniques.

In some embodiments, once the cavities have been etched into the second side of the substrate, powder of a magnetic material may be filled into the cavities. For example, one or more apparatus(es) may fill powder of a magnetic material (e.g., NdFeB powder) into the cavities and may then brush off excess powder on the second side of the substrate. Any known technique for filling cavities with a material may be utilized, and apparatus(es) 1710 may include any known apparatus for performing any of these known techniques, such as a vibration plate as just one example.

In some embodiments, once the powder of magnetic material has been filled into the cavities, an atomic layer deposition process may be performed to solidify the magnetic powder into magnet structures embedded within the cavities. Any known technique for performing an atomic layer deposition process may be utilized, and apparatus(es) 1710 may include any known apparatus for performing any of these known techniques. Once the magnet structures have been embedded in the cavities, the substrate may be passed by conductive coils to magnetize the magnet structures.

FIG. 17 is a block diagram of an example environment 1700 for implementing embodiments of the present disclosure, in accordance with some embodiments. For example, environment 1700 may perform a process for etching cavities into a substrate to layout a biasing magnet comprised of a plurality of magnet structures, or for otherwise constructing a biasing magnet comprised of a plurality of magnet structures embedded (integrated) into a substrate.

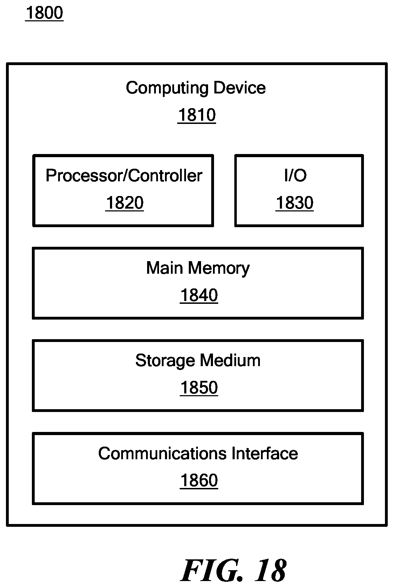

As shown in FIG. 17, environment 1700 may include one or more computing system(s) 1730. Computing system(s) 1730 may include one or more computing devices (see, e.g., computing device(s) 1810 of FIG. 18). A computing device may be, for example, a computing device that may be used to perform some or all of process 1600 of FIG. 16. A computing device 1810 may be a computer, such as a laptop computer, desktop computer, mobile phone, tablet, personal computer, server computer, or other type of computer.

Apparatus(es) 1710 may include one or more apparatuses for manufacturing an IC or semiconductor device, such as a magnetic field sensor device. Apparatus(es) 1710 may include, for example, one or more apparatuses for depositing layers of material, one or more apparatuses for etching a substrate (e.g., Silicon wafer), one or more apparatuses for cutting a substrate, one or more apparatuses for cleaning or polishing a substrate, one or more apparatuses for depositing a powder of magnetic material into cavities of a substrate, and/or one or more apparatuses for performing an atomic layer deposition process on a powder of magnetic material filled into cavities of a substrate. In some embodiments, apparatus(es) 1710 may receive a mask or instructions for depositing material, etching a substrate, cleaning or polishing a substrate, depositing material into cavities of a substrate, and/or performing an atomic layer deposition process over one or more networks 1720 from one or more computing systems 1730.

Network(s) 1720 may include, for example, one or more wired and/or wireless networks. By way of example, network(s) 1720 may include an Ethernet network, a WiFi network, a Universal Serial Bus (USB) network, a local area network (LAN), and wide area network (WAN), a cellular (e.g., 5G) network, and/or any other suitable type of network.

FIG. 18 is a block diagram 1800 of a computing device 1810, consistent with embodiments of the present disclosure. Computing device 1810 may, for example, perform part of all of process 1600 of FIG. 16. As shown in FIG. 18, a computing device 1810 may include one or more processors or controllers 1820 for executing instructions. Processors or controllers suitable for the execution of instructions may include, by way of example, both general and special purpose (e.g., application specific integrated circuit (ASIC) processors or controllers. A computing device 1810 may also include one or more input/output (I/O) devices 1830. By way of example, I/O devices 1830 may include keys, buttons, mice, joysticks, styluses, etc. Keys and/or buttons may be physical and/or virtual (e.g., provided on a touch screen interface). A computing device 1810 may be connected to one or more displays (not shown) via I/O 1830. A display may be implemented using one or more display panels, which may include, for example, one or more cathode ray tube (CRT) displays, liquid crystal displays (LCDs), plasma displays, light emitting diode (LED) displays, touch screen type displays, organic light emitting diode (OLED) displays, or any other type of suitable display.

A computing device 1810 may include one or more storage devices configured to store data and/or software instructions used by processor(s) or controller(s) 1820 to perform operations consistent with disclosed embodiments. For example, computing device 1810 may include main memory 1840 configured to store one or more software programs that, when executed by processor(s) or controller(s) 1820, cause processor(s) or controller(s) 1820 to perform functions or operations consistent with disclosed embodiments.

By way of example, main memory 1840 may include NOR and/or NAND flash memory devices, read only memory (ROM) devices, random access memory (RAM) devices, etc. A computing device 1810 may also include one or more storage mediums 1850. By way of example, storage medium(s) 1850 may include hard drives, solid state drives, etc. A computing device 1810 may include any number of main memories 1840 and storage mediums 1850. A main memory 1840 or storage medium 1850 may, in some embodiments, be a non-transitory computer-readable medium.

A computing device 1810 may further include one or more communication interfaces 1860. Communication interface(s) 1860 may allow one or more signals to be received from apparatus(es) 1710 over one or more networks 1720, and may allow one or more signals to be transmitted to apparatus(es) 1710. Example communication interface(s) 1760 include a modem, network interface card (e.g., Ethernet card), a communications port, an antenna, a WiFi interface, an Ethernet a Universal Serial Bus (USB) interface, a local area network (LAN) network interface, a cellular (e.g., 5G) interface, and/or any other suitable type of interface for transmitting and/or receiving signals or other information. Communication interface(s) 1860 may transmit software, data, masks, instructions, or information in the form of signals, which may be electronic, electromagnetic, optical, and/or other types of signals. The signals may be provided to/from communications interface 1860 via a communications path (e.g., network(s) 1720), which may be implemented using wired, wireless, cable, fiber optic, radio frequency (RF), and/or other communications channels.

As used herein, the term "processor" or "controller" is used to describe electronic circuitry that performs a function, an operation, or a sequence of operations. The function, operation, or sequence of operations can be hard coded into the electronic circuit or soft coded by way of instructions held in a memory device. The function, operation, or sequence of operations can be performed using digital values or using analog signals. In some embodiments, the processor or controller can be embodied in an application specific integrated circuit (ASIC), which can be an analog ASIC or a digital ASIC, in a microprocessor with associated program memory and/or in a discrete electronic circuit, which can be analog or digital. A processor or controller can contain internal processors or modules that perform portions of the function, operation, or sequence of operations. Similarly, a module can contain internal processors or internal modules that perform portions of the function, operation, or sequence of operations of the module.

While electronic circuits shown in figures herein may be shown in the form of analog blocks or digital blocks, it will be understood that the analog blocks can be replaced by digital blocks that perform the same or similar functions and the digital blocks can be replaced by analog blocks that perform the same or similar functions. Analog-to-digital or digital-to-analog conversions may not be explicitly shown in the figures but should be understood.

Various embodiments of the systems, methods, and techniques are described herein with reference to the related drawings. Alternative embodiments can be devised without departing from the scope of the described concepts. It is noted that various connections and positional relationships (e.g., over, below, adjacent, etc.) are set forth between elements in the following description and in the drawings. These connections and/or positional relationships, unless specified otherwise, can be direct or indirect, and the present invention is not intended to be limiting in this respect. Accordingly, a coupling of entities can refer to either a direct or an indirect coupling, and a positional relationship between entities can be a direct or indirect positional relationship. As an example of an indirect positional relationship, references in the present description to element or structure A over element or structure B include situations in which one or more intermediate elements or structures (e.g., element C) is between elements A and B regardless of whether the characteristics and functionalities of elements A and/or B are substantially changed by the intermediate element(s).

Furthermore, it should be appreciated that relative, directional or reference terms (e.g. such as "above," "below," "left," "right," "top," "bottom," "vertical," "horizontal," "front," "back," "rearward," "forward," etc.) and derivatives thereof are used only to promote clarity in the description of the figures. Such terms are not intended as, and should not be construed as, limiting. Such terms may simply be used to facilitate discussion of the drawings and may be used, where applicable, to promote clarity of description when dealing with relative relationships, particularly with respect to the illustrated embodiments. Such terms are not, however, intended to imply absolute relationships, positions, and/or orientations. For example, with respect to an object or structure, an "upper" or "top" surface can become a "lower" or "bottom" surface simply by turning the object over. Nevertheless, it is still the same surface and the object remains the same. Also, as used herein, "and/or" means "and" or "or," as well as "and" and "or." Moreover, all patent and non-patent literature cited herein is hereby incorporated by references in their entirety.

The terms "disposed over," "overlying," "atop," "on top," "positioned on" or "positioned atop" mean that a first element, such as a first structure, is present on a second element, such as a second structure, where intervening elements or structures (such as an interface structure) may or may not be present between the first element and the second element. The term "direct contact" means that a first element, such as a first structure, and a second element, such as a second structure, are connected without any intermediary elements or structures between the interface of the two elements. The term "connection" can include an indirect connection and a direct connection.

The terms "approximately," "substantially," or "about" may be used to mean within +/- 30% of a target value in some embodiments, within +/- 20% of a target value in some embodiments, within +/- 10% of a target value in some embodiments, within +/- 5% of a target value in some embodiments, and within +/- 2% of a target value in some embodiments. The aforementioned terms may also include the target value.

In the foregoing detailed description, various features are grouped together in one or more individual embodiments for the purpose of streamlining the disclosure. This method of disclosure is not to be interpreted as reflecting an intention that each claim requires more features than are expressly recited therein. Rather, inventive aspects may lie in less than all features of each disclosed embodiment.

References in the disclosure to "one embodiment," "an embodiment," "some embodiments," or variants of such phrases indicate that the embodiment(s) described can include a particular feature, structure, or characteristic, but every embodiment can include the particular feature, structure, or characteristic. Moreover, such phrases are not necessarily referring to the same embodiment(s). Further, when a particular feature, structure, or characteristic is described with reference to one embodiment, knowledge of one skilled in the art may be relied upon to affect such feature, structure, or characteristic in connection with other embodiments whether or not explicitly described.

The disclosed subject matter is not limited in its application to the details of construction and to the arrangements of the components set forth in the following description or illustrated in the drawings. The disclosed subject matter is capable of other embodiments and of being practiced and carried out in various ways. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

All publications and references cited herein are expressly incorporated herein by reference in their entirety.

**Claims**

1. A sensor device, comprising:

a plurality of magnetic field sensing elements formed into bridge circuits on a first side of a semiconductor die; and
a plurality of magnet structures embedded in a second side of the semiconductor die.

2. The sensor device of claim 1, wherein the plurality of magnetic field sensing elements comprise one or more giant magnetoresistance (GMR) elements, one or more tunneling magnetoresistance (TMR) elements, or one or more Hall plate elements.

3. The sensor device of claim 1, wherein the plurality of magnet structures generate a magnetic field that biases the plurality of magnetic field sensing elements along a first axis, and wherein the plurality of magnetic field sensing elements are maximally sensitive to the magnetic field along a second axis that is orthogonal to the first axis.

4. The sensor device of claim 1, wherein a first magnet structure of the plurality of magnet structures has a first volume and a second magnet structure of the plurality of magnet structures has a second volume different than the first volume.

5. The sensor device of claim 1, wherein the semiconductor die has a first axis and the plurality of magnet structures are symmetrical about the first axis.

6. The sensor device of claim 5, wherein the semiconductor die has a second axis and the plurality of magnet structures are symmetrical about the second axis.

7. The sensor device of claim 6, wherein the first axis is orthogonal to the second axis.

8. The sensor device of claim 1, wherein walls of the semiconductor die surround the plurality of magnet structures.

9. The sensor device of claim 1, wherein at least some of the plurality of magnet structures have dimensions that differ from others of the plurality of magnet structures.

10. The sensor device of claim 1, wherein the plurality of magnet structures generate a magnetic field, and wherein the plurality of magnetic field sensing elements comprise at least four magnetic field sensing elements configured to sense a deflection of the magnetic field caused by a target that rotates in proximity to the sensor device.

11. The sensor device of claim 10, wherein each of the magnetic field sensing elements comprises a first segment and a second segment, and the magnetic field applies a bias that is the same along a first axis of the first segments of each of the at least four magnetic field sensing elements on average over a period of a rotation of the target.

12. The sensor device of claim 10, wherein the magnetic field applies no bias along a second axis of each of the at least four magnetic field sensing elements on average over a period of a rotation of the target.

13. The sensor device of claim 10, wherein the magnetic field generated by the plurality of magnet structures applies a constant bias across a region of the first side of the semiconductor die on average over a period of rotation of the target.

14. The sensor device of claim 10, wherein the magnetic field generated by the plurality of magnet structures applies a bias across each of at least four regions of the first side of the semiconductor die, and wherein the bias applied to each of the at least four regions is constant across that region on average over a period of rotation of the target.

**15.** The sensor device of claim 1, wherein each of the plurality of magnet structures is formed in a respective cavity in the second side of the semiconductor die.

**16.** The sensor device of claim 15, wherein at least one of the cavities has a top along the second side of the semiconductor die and a bottom within the semiconductor die, wherein the at least one cavity is formed with an undercut such that the bottom is wider than the top.

**17.** A method, comprising:

identifying regions of a first side of a semiconductor die for placement of magnetic field sensing elements;
dimensioning a plurality of magnet structures for a second side of the semiconductor die;
generating a mask for etching cavities into the second side of the semiconductor die based at least in part on the dimensioning of the plurality of magnet structures; and
causing the cavities to be etched into the second side of the semiconductor die based on the mask.

**18.** The method of claim 17, further comprising causing the magnetic field sensing elements to be formed onto the regions of the first side of the semiconductor die.

**19.** The method of claim 18, wherein the magnetic field sensing elements comprise at least one of a giant magnetoresistance (GMR) element, a tunneling magnetoresistance (TMR) element, or a Hall plate element.

**20.** The method of claim 19, wherein the magnetic field sensing elements are configured to be biased by a magnetic field generated by the plurality of magnet structures along a first axis, and to be maximally sensitive to the magnetic field along a second axis orthogonal to the first axis.

**21.** The method of claim 18, further comprising dimensioning the plurality of magnet structures to generate a magnetic field, wherein the magnetic field sensing elements comprise at least four magnetic field sensing elements configured to sense a deflection of the magnetic field caused by a target that rotates in proximity to the sensor device.

**22.** The method of claim 21, further comprising dimensioning the plurality of magnet structures to generate the magnetic field to apply a bias that is the same along a first axis of each of the regions on average over a period of rotation of the target.

**23.** The method of claim 21, further comprising dimensioning the plurality of magnet structures to generate the magnetic field such that no bias is applied along a second axis of each of the regions on average over a period of rotation of the target.

**24.** The method of claim 21, further comprising dimensioning the plurality of magnet structures to generate the magnetic field such that the bias applied to each of the regions is constant across that region over a period of rotation of the target.

**25.** The method of claim 17, further comprising causing at least one of the cavities of the semiconductor die to be etched such that the at least one cavity has a top along the second side of the semiconductor die, a bottom within the semiconductor die, and an undercut along at least one side of the cavity, such that the bottom is wider than the top.

**26.** The method of claim 17, further comprising:

dimensioning the semiconductor die to form one or more walls between a set of two or more of the magnet structures; and
generating the mask for etching the cavities based at least in part on the dimensioning of the one or more walls.

10

TARGET
14

SENSOR
ELEMENT

12

→

SIGNAL
PROCESSING
MODULE

16

→

OUTPUT
MODULE

20

MAGNET
13

## FIG. 1A

100

116    110    V$_{CC}$    120

126    112

124

118    114

122

DIFF
AMP
CIRCUIT

130

OUTPUT
MODULE

140

## FIG. 1B

**FIG. 2A**

**FIG. 2B**

EP 4 741 859 A2

**FIG. 3**

EP 4 741 859 A2

*FIG. 4*

**FIG. 5**

**FIG. 6**

<u>630</u> Left bridge

635

$A_{la}$  $B_{la}$

$A_l$  $B_l$

$A_{lb}$  $B_{lb}$

637  642

$B_{cla}$  $A_{ca}$

$B_{cl}$  $A_c$

$B_{clb}$  $A_{cb}$

640

<u>650</u> Right bridge

635

$B_{cra}$  $C_{ca}$

$B_{cr}$  $C_c$

$B_{crb}$  $C_{cb}$

657  662

$C_{ra}$  $B_{ra}$

$C_r$  $B_r$

$C_{rb}$  $B_{rb}$

640

## FIG. 6A

<u>670</u> Symmetric bridge

635

$A_l$  $C_c$

677  682

$C_r$  $A_c$

640

<u>690</u> Three point bridge

635

$B_{cr}$  $A_l$

693  696

$C_r$  $B_r$

640

## FIG. 6B

30

**FIG. 7A**

**FIG. 7B**

**FIG. 8A**

**FIG. 8B**

*FIG. 9A*

*FIG. 9B*

FIG. 9C

**FIG. 10**

FIG. 11

EP 4 741 859 A2

**FIG. 12**

**FIG. 13**

1300

815 810 1380 1370 1360 1350 1340 1330 1320 1310

755 — Y (mm)

760

X (mm)

**FIG. 14**

EP 4 741 859 A2

1500

**FIG. 15A**

**FIG. 15B**

1600

```
┌─────────────────────────────────────────────┐
│  Identifying regions of a first side of a     │
│  substrate for placement of magnetic field    │
│  sensing elements                             │
│                  1610                         │
└─────────────────────────────────────────────┘
                      │
                      ▼
┌─────────────────────────────────────────────┐
│  Dimensioning a plurality of magnetic          │
│  structures for a second side of the substrate │
│                  1620                         │
└─────────────────────────────────────────────┘
                      │
                      ▼
┌─────────────────────────────────────────────┐
│             Generating a mask                 │
│                  1630                         │
└─────────────────────────────────────────────┘
                      │
                      ▼
┌─────────────────────────────────────────────┐
│  Causing cavities to be etched in the second   │
│  side of the substrate                        │
│                  1640                         │
└─────────────────────────────────────────────┘
```

*FIG. 16*

1700

```
┌──────────────┐          ╭─────────╮          ┌──────────────┐
│ Apparatus(es)│ ◄──────► │Network(s)│ ◄──────► │  Computing   │
│     1710     │          │   1720   │          │  system(s)   │
└──────────────┘          ╰─────────╯          │     1730     │
                                                └──────────────┘
```

*FIG. 17*

1800

Computing Device
1810

| Processor/Controller | I/O |
|---|---|
| 1820 | 1830 |

Main Memory
1840

Storage Medium
1850

Communications Interface
1860

*FIG. 18*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9221217 B
- US 20240065109

- US 20230332878

**Non-patent literature cited in the description**

- A Novel Fabrication Technique for MEMS Based on Agglomeration of Powder by ALD. *Journal of Microelectromechanical Systems*, October 2017, vol. 26 (5)
- Fully Integrated Back-Biased 3D Hall Sensor with Wafer-level Integrated Permanent Micromagnets. *IEEE MEMS*, 2023

- Demonstration of Fully Integrable Long-Range Microposition Detection with Wafer-Level Embedded Micromagnets. *Micromachines*, 2022
- Investigation of Wafer-Level Fabricated Permanent Micromagnets for MEMS. *Micromachines*, 2022
- PowderMEMS - A Generic Microfabrication Technology for Integrated Three-Dimensional Functional Microstructures. *Micromachines*, 2022